(19) Europäisches Patentamt
European Patent Office
Office européen des brevets

(11) **EP 4 498 768 A1**

(12) **EUROPEAN PATENT APPLICATION**
published in accordance with Art. 153(4) EPC

(43) Date of publication:
**29.01.2025 Bulletin 2025/05**

(21) Application number: **23774341.4**

(22) Date of filing: **17.02.2023**

(51) International Patent Classification (IPC):
***H05K 1/16*** (2006.01)

(52) Cooperative Patent Classification (CPC):
**H05K 1/16**

(86) International application number:
**PCT/JP2023/005791**

(87) International publication number:
**WO 2023/181742 (28.09.2023 Gazette 2023/39)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **22.03.2022 JP 2022045431**

(71) Applicant: **AJINOMOTO CO., INC.**
**Chuo-ku**
**Tokyo 104-8315 (JP)**

(72) Inventors:
• **TANAKA, Takayuki**
**Kawasaki-shi, Kanagawa 210-0801 (JP)**
• **HOMMA, Tatsuya**
**Kawasaki-shi, Kanagawa 210-0801 (JP)**

(74) Representative: **Mewburn Ellis LLP**
**Aurora Building**
**Counterslip**
**Bristol BS1 6BX (GB)**

(54) **MANUFACTURING METHOD FOR MAGNETIC SUBSTRATE**

(57)    A production method for a magnetic substrate using a resin sheet that comprises a support and a resin composition layer formed on the support; wherein the resin composition layer comprises a resin composition containing a magnetic powder; the production method comprises a step (I) of placing the resin sheet on a core substrate having a through hole formed therein, and a step (II) of pressing the resin sheet with a rigid plate to fill the through hole with the resin composition; and the step (II) includes performing the pressing in such a way that the rigid plate is in contact with the resin sheet, under heating condition of 80°C or higher and 160°C or lower in an environment with a vacuum degree of 1.3 kPa or less.

FIG.1

EP 4 498 768 A1

**Description**

Technical Field

The present invention relates to a production method for a magnetic substrate.

Background Art

One of the circuit board used in an electronic device is the one that is obtained by filling a through hole in a core substrate with a resin composition and curing the resin composition (Patent Literatures 1, 2, and 3). As the resin composition that is used in order to fill a through hole in a circuit board for an inductor component, a resin composition containing a magnetic powder may be used (Patent Literature 4). The circuit board that uses the resin composition containing the magnetic powder includes the core substrate formed with the through hole and a cured product of the resin composition that is filled in the through hole. The cured product described above can be used as the magnetic material because it contains the magnetic powder. Hereinafter, the substrate having the through hole therein filled with the material that contains a magnetic powder may be referred to as a "magnetic substrate".

Citation List

Patent Literature

   Patent Literature 1: Japanese Patent Application Laid-open No. 2004-149758
   Patent Literature 2: Japanese Patent No. 4992514
   Patent Literature 3: Japanese Patent Application Laid-open No. 2016-100546
   Patent Literature 4: Japanese Patent Application Laid-open No. 2021-86856

Summary of the Invention

Technical Problem

When a magnetic material is used to produce an inductor component having superior characteristics, a high magnetic permeability is required in the magnetic material. In order to obtain the magnetic material having a high magnetic permeability as a cured product of a resin composition, it is desirable to increase the content of the magnetic powder in the resin composition.

Conventionally, as a method for filling a through hole with a resin composition that contains a magnetic powder, a printing method such as a screen printing method has been used. However, when the content of the magnetic powder is high, the resin composition has a low fluidity thereby having a poor printing performance. Thus filling by the printing method is difficult. Therefore, the inventor of the present invention has studied the method how to fill the through hole well with the resin composition even when the content of the magnetic powder in the resin composition is increased.

Specifically, the inventor of the present invention has studied the method for filling the through hole with the resin composition by using a resin sheet that comprises a support and a resin composition layer formed on the support. However, when the through hole is filled with the resin composition by using the resin sheet, an unfilled portion or a void is formed, so that it has been difficult to fill the through hole sufficiently well.

For example, the inventor of the present invention has attempted to fill the through hole with the resin composition by laminating the resin sheet with a core substrate using a vacuum laminator. Generally, in a vacuum laminator, a resin sheet is pressed with an elastic member in a vacuum environment to laminate the resin sheet with the core substrate. For this, generally used examples include a rubber press method in which a pressure is applied by an elastic frame formed of a rubber, and a diaphragm method in which a pressure is applied by a membrane formed of an elastic material. When applying a pressure using such an elastic member, the vacuum laminator is expected to be able to laminate without forming a vacant space because it is presumed that the resin sheet can follow the surface shape of the core substrate sufficiently. However, when the vacuum laminator is used, it has not been possible to fill the entire through hole with the resin composition, so that an unfilled portion not having the resin composition may be formed.

Therefore, the inventor of the present invention has attempted to use a 2-chamber vacuum laminator. The 2-chamber vacuum laminator laminates the resin sheet with the core substrate in a first chamber under a vacuum environment as described above, and then, in a second chamber, the laminator presses the resin sheet under an environment of an atmospheric pressure. In general, the 2-chamber vacuum laminator is designed for a fully automated continuous production, and the resin sheet is customarily pressed with a smooth flat plate in the second chamber in order to smooth the resin composition layer. When the additional pressing of the resin composition in the second chamber is carried out, it is expected that the resin composition would further penetrate into the through hole thereby enabling to suppress the formation of the unfilled portion. However, when the 2-chamber vacuum laminator is used, a void (air bubble) is formed in the resin composition.

In addition, for example, the inventor of the present invention has attempted to fill the through hole with the resin composition by laminating the resin sheet with the core substrate by using a vacuum hot press. In general, in the vacuum hot press, the resin sheet and the core substrate are heated under a high pressing condition in a vacuum environment for a long period of time (Japanese Patent No. 6812091). Because of the conditions of a high temperature and a high pressure with a long duration period, in general, a high level of vacuum degree is not necessary in the vacuum hot press, so that it is expected to achieve the lamination with a reduced cost associated with evacuation. However, when the vacuum hot press is used, it has been found that a void is formed upon observing the cured product of the resin composition formed in the through hole.

The inventor of the present invention has further studied, and as a result, it has been found that, when the thickness of the resin composition layer of the resin sheet is increased, the through hole can be filled with the resin composition by the vacuum laminator. However, when using the resin sheet, the resin composition usually adheres not only inside the through hole but also onto the main surface of the core substrate. When the resin composition layer is thick, the amount of the resin composition adhering onto the main surface of the core substrate increases. In general, when the resin composition adheres to the main surface of the core substrate, the cured product thereof is removed by polishing after the resin composition is cured. However, the cured product of the resin composition that contains a magnetic powder has low polishability, so that the load in the polishing process is heavy. Therefore, when the amount of the cured product increases, the time and energy for polishing increases. Accordingly, it is desirable to use the method with which the through hole can be filled with the resin composition even when the resin composition layer is thin.

The present invention has been conceived in view of the aforementioned problem, and thus has an object to provide the production method for a magnetic substrate with which a through hole of a core substrate can be filled with a resin composition by using a resin sheet while suppressing the formation of a void and an unfilled portion.

Solution to Problem

The inventor of the present invention extensively studied how to solve the problem described above. As a result, the inventor has found that, with the method that includes pressing a resin sheet by means of a rigid plate under a particular heating condition and at a particular vacuum degree, the through hole can be filled with the resin composition while suppressing formation of a void and an unfilled portion, and thus has completed the present invention.

Thus, the present invention includes the following aspects.

<1> A production method for a magnetic substrate using a resin sheet that comprises a support and a resin composition layer formed on the support; wherein

the resin composition layer comprises a resin composition containing a magnetic powder;
the production method comprises
a step (I) of placing the resin sheet on a core substrate having a through hole formed therein, and
a step (II) of pressing the resin sheet with a rigid plate to fill the through hole with the resin composition; and
the step (II) includes performing the pressing in such a way that the rigid plate is in contact with the resin sheet, under heating condition of 80°C or higher and 160°C or lower at a vacuum degree of 1.3 kPa or less.

<2> The production method for the magnetic substrate according to <1>, wherein

the step (I) includes placing the resin sheets on both sides of the core substrate, and
the step (II) includes pressing the resin sheets placed on both sides of the core substrate with the rigid plate.

<3> The production method for the magnetic substrates according to <1> or <2>, wherein the pressing at the step (II) is performed under the pressure condition of 5 kgf/cm$^2$ or higher.
<4> The production method for the magnetic substrate according to any one of <1> to <3>, including a step (III) of curing the resin composition after the step (II).
<5> The production method for the magnetic substrate according to <4>, including a step (IV) of polishing the cured resin composition after the step (III).
<6> The production method for the magnetic substrate according to <4> or <5>, wherein

the step (III) includes forming a cured product layer comprising a cured product of the resin composition in the through hole; and

the production method includes, after the step (III), a step (V) of forming a through hole in the cured product layer in the through hole.

<7> The production method for the magnetic substrate according to any one of <4> to <6>, including a step (VI) of forming a conductor layer after the step (III).

<8> The production method for the magnetic substrate according to any one of <1> to <7>, wherein an amount of the magnetic powder is 65% by volume or more relative to 100% by volume of nonvolatile components in the resin composition.

<9> The production method for the magnetic substrate according to any one of <1> to <8>, wherein a thickness of the resin composition layer included in the resin sheet is 150 μm or less.

Advantageous Effects of Invention

The present invention can provide the production method for a magnetic substrate capable of filling the through hole in the core substrate with a resin composition by using a resin sheet while suppressing formation of a void and an unfilled portion.

Brief Description of Drawings

FIG. 1 is a schematic cross sectional view illustrating the laminator used in the production method according to the first specific example of the present invention.

FIG. 2 is a schematic cross sectional view illustrating the magnetic substrate obtained by the production method according to the first specific example of the present invention.

FIG. 3 is a schematic cross sectional view illustrating the magnetic substrate obtained by the production method according to the first specific example of the present invention.

FIG. 4 is a schematic cross sectional view illustrating the magnetic substrate obtained by the production method according to the first specific example of the present invention.

FIG. 5 is a schematic cross sectional view illustrating the magnetic substrate obtained by the production method according to the first specific example of the present invention.

FIG. 6 is a schematic cross sectional view illustrating the magnetic substrate obtained by the production method according to the first specific example of the present invention.

FIG. 7 is a schematic cross sectional view illustrating the laminator used in the production method according to the second specific example of the present invention.

Description of Embodiments

Hereinafter, the present invention will be described in detail by embodiments and examples. The present invention is not limited to the embodiments and examples described below; thus, the present invention may be carried out with any modification so far as such modification is not outside the claims or the equivalent thereof.

<Outline of the production method for the magnetic substrate>

The production method for the magnetic substrate according to one embodiment of the present invention is a production method for producing a magnetic substrate using a resin sheet comprising a support and a resin composition layer formed on the support. The resin composition layer contains a resin composition including a magnetic powder, and preferably contains only the resin composition. This production method includes

a step (I) of placing the resin sheet on a core substrate having a through hole formed therein, and

a step (II) of pressing the resin sheet with a rigid plate to fill the through hole with a resin composition. Hereinafter, the above-mentioned through hole formed in the core substrate may be referred to as a "first through hole". At the step (I), the resin sheet is placed on the core substrate in such a way that the core substrate and the resin composition layer are in contact with each other. Then, at the step (II), the resin sheet is pressed by means of the rigid plate to fill the first through hole with the resin composition contained in the resin composition layer.

The step (II) of the production method for the magnetic substrate according to one embodiment of the present invention includes pressing of the rigid plate to the resin sheet in such a way that the rigid plate is in contact with the resin sheet under an environment of a particular range of a vacuum degree. According to the step (II) described above, the resin composition can be caused to smoothly enter the first through hole. Therefore, the first through hole can be filled with the resin composition without a vacant space, and thus it is possible to suppress formation of an unfilled portion not having the resin composition in the first through hole. According to the step (II) described above, it is possible to suppress formation of a void (air bubble) in the resin composition. Therefore, both the formation of the void and the formation of the unfilled portion can be suppressed, so that a superior filling performance can be achieved. Accordingly, the magnetic substrate including the core substrate and the resin composition that well fills the core substrate can be obtained.

Usually, the production method for the magnetic substrate according to one embodiment of the present invention further includes,

after the step (II), a step (III) of curing the resin composition.

When the resin composition filled in the first through hole is cured, the magnetic substrate including the core substrate and the cured product of the resin composition that fills the first through hole in the core substrate can be obtained.

The inventor of the present invention presumes the mechanism with which the aforementioned advantageous effects can be obtained by the production method according to the present embodiment as follows. However, the technical scope of the present invention is not limited to the following mechanism.

When the resin sheet is pressed with an elastic member, as in the method using a vacuum laminator, a part of the pressure is consumed for deformation of the elastic member. Therefore, the pressure exerted on the resin composition may be insufficient, and thus an insufficient amount of the resin composition may enter the first through hole. During the pressing, the elastic member under pressure may be deformed, resulting in blocking of the opening of the first through hole. When the opening is blocked by the elastic member, there may be the case that the resin composition cannot enter the first through hole anymore, thereby leading to formation of an unfilled portion in the first through hole.

In the method using a vacuum hot press, heating is performed at a high pressure condition for a long time, so it may be expected to suppress the formation of the unfilled portion. However, the vacuum hot press, by its own nature, does not provide a high level of vacuum environment at a high cost. Therefore, a gas is prone to reside in the pressing machine, so that a void is usually formed. The circumstances in which the void is formed by a gas in the pressing environment are the same as in the method of pressing the resin sheet with a flat plate using the 2-chamber vacuum laminator. A second chamber of the 2-chamber vacuum laminator generally aims to achieve smoothing by pressing the resin sheet with a flat plate; and because there is no motivation in a person ordinarily skilled in the art to create a vacuum environment at a high cost, it has not been possible to suppress the formation of the void.

In contrast, in the production method according to the present embodiment, the resin sheet is pressed with a rigid plate under a vacuum environment having a high level of vacuum degree. The rigid plate does not waste the pressure due to the elastic deformation. Thus a sufficiently large pressure can be exerted on the resin composition. As a result, a sufficient amount of the resin composition can enter the first through hole. In addition, the rigid plate does not block the opening of the first through hole due to the deformation. Moreover, under a vacuum environment having a high level of vacuum degree, the residing gas is little enough to be neglected, so that remaining of the gas in the resin composition and in the cured product thereof can be suppressed. Therefore, the formation of the void and the unfilled portion can be suppressed, thereby achieving a superior filling performance.

<Step (I)>

The production method for the magnetic substrate according to one embodiment of the present invention includes the step (I) of placing the resin sheet on the core substrate. Usually, the resin sheet is placed such that the core substrate and the resin composition layer are in contact with each other.

The core substrate is a substrate having the first through hole formed therein and is usually includes a supporting substrate. Illustrative examples of the supporting substrate may include insulating substrates such as a glass epoxy substrate, a metal substrate, a polyester substrate, a polyimide substrate, a BT resin substrate, and a thermosetting type polyphenylene ether substrate. On the supporting substrate, a conductor layer may be formed. The conductor layer may be formed on one surface of the supporting substrate, or on both surfaces of the supporting substrate. Illustrative examples of the conductor layer may include a layer formed of a metal such as copper. The conductor layer may be, for example, a copper foil such as a carrier-attached copper foil. The conductor layer may be a layer of the same material as the conductor layer described in the step (V) to be described later. The conductor layer may be formed on the inner surface of the first through hole.

Usually, the first through hole goes through the core substrate in the thickness direction. Therefore, the first through hole has openings on both main surfaces (i.e., front and back surfaces) of the core substrate. The shape of the openings of the first through hole is not particularly restricted, so that this may be of any shape, such as rectangular, circular, roughly rectangular, and roughly circular. The size of the opening is depending on the design of the magnetic substrate. For example, when the shape of the opening is rectangular, the size thereof is preferably 5 mm x 5 mm or less, and more preferably 3 mm x 3 mm or less, or 2 mm x 2 mm or less. When the shape of the opening is circular, the diameter thereof is preferably 5 mm or less, and more preferably 3 mm or less, or 2 mm or less. The lower limit of the size of the opening is depending on the design of the magnetic substrate. In the case of the rectangular opening, the size thereof may be usually 0.2 mm x 0.2 mm or more. In the case of the circular opening, the diameter thereof may be usually 0.2 mm or more. When a circuit board is used as the core substrate, the opening is usually formed in the region of the circuit board where a circuit wiring is not formed.

For example, the core substrate may be produced by forming, to the core substrate before the first through hole is formed, the first through hole by processing method such as drilling, laser irradiation, and plasma irradiation, which is then followed further, if necessary, by forming a conductor layer by forming method such as plating method. The core substrate may be prepared by purchasing from a market.

The resin sheet includes a support and a resin composition layer. As the support, usually, a member in the form of a film or of a sheet may be used. The resin composition layer is formed on the support. The resin composition layer contains a resin composition including a magnetic powder. This resin composition is filled into the first through hole of the core substrate at the step (II). Details of the resin sheet will be described later.

At the step (I), the resin sheet is usually placed in such a way that the resin composition layer covers the opening of the first through hole that is open on the main surface of the core substrate. The resin sheet may be placed on one or both sides of the core substrate. From the viewpoint of suppressing warpage of the magnetic substrate to be produced, it is preferable to place the resin sheet on both sides of the core substrate. Therefore, it is preferable that the step (I) includes placing the resin sheet on both sides of the core substrate. Placing the resin sheet on one side of the core substrate and placing the resin sheet on the other side of the core substrate may be carried out simultaneously or in sequence. The thickness of the resin composition layer of the resin sheet placed on one side of the core substrate and the thickness of the resin composition layer of the resin sheet placed on the other side of the core substrate may be different, but it is preferable that they are the same from the viewpoint of easy polishing of the cured product of the resin composition.

When the resin sheet is placed on the core substrate, the resin sheet may be placed such that it is partially in contact with the core substrate, or the resin composition layer may be thoroughly in contact with the core substrate.

<Step (II)>

The production method for the magnetic substrate according to one embodiment of the present invention includes, after the step (I), the step (II) of pressing the resin sheet with a rigid plate to fill the resin composition into the first through hole. When the resin sheet is pressed by means of the rigid plate, the resin composition contained in the resin composition layer flows and enters the first through hole in the core substrate thereby filling the first through hole.

The rigid plate represents a plate that is formed of a rigid material. As the rigid material, a material that has rigidity enough to fill the first through hole in the core substrate with the resin composition may be used. As the rigid material, a material that does not deform during pressing, i.e., the material that does not deform under the pressing and heating conditions at the step (II) is preferable; and a metallic material is especially preferable. Illustrative examples of the metallic material may include iron, aluminum, and an alloy of these metals. Examples of the alloy may include a stainless steel. Among them, a stainless steel is especially preferable because of its superior rust resistance.

The rigid plate has a pressuring surface capable of pressing the resin sheet by contacting the resin sheet. Usually, this pressing surface is a smooth flat surface. In addition, the pressing surface has high rigidity and, therefore, is not usually deformed by the pressure during pressing. In one example, the HV hardness of the pressing surface of the rigid plate is preferably 150 or more, more preferably 200 or more, and still more preferably 300 or more, and is preferably 1000 or less, and more preferably 700 or less. The HV hardness is also called Vickers hardness and may be measured according to JIS Z 2244.

The thickness of the rigid plate is not restricted as long as the resin composition can fill the first through hole of the core substrate. In one example, the range of the thickness of the rigid plate is preferably 0.1 mm or more, more preferably 1 mm or more, and is preferably 10 mm or less, and more preferably 5 mm or less.

The pressing of the resin sheet at the step (II) is performed in such a way that the rigid plate is in contact with the resin sheet. The term "the rigid plate in contact with the resin sheet" means that there is no optional layer such as a rubber membrane between the rigid plate and the resin sheet. Usually, the pressing surface of the rigid plate contacts the resin sheet, and the pressing surface presses the resin sheet to achieve the pressing. Since the optional layer is not exist between the rigid plate and the resin sheet, greater pressure can be applied onto the entire resin sheet. Therefore, not only the resin composition on the opening of the first through hole but also the resin composition around the opening portion can enter the first through hole by a large pressure. Consequently, filling of the first through hole can be carried out smoothly.

The pressing of the resin sheet at the step (II) is performed in a particular range of the vacuum degree. Usually, at the step (II), the resin sheet is pressed in an enclosed space having the particular range of the vacuum degree. Therefore, the pressing of the resin sheet may be performed in the environment in the enclosed space having the particular range of the vacuum degree. The range of the vacuum degree is usually 1.3 kPa or less, preferably 1.0 kPa or less, more preferably 0.5 kPa or less, and especially preferably 0.2 kPa or less. The lower limit thereof is ideally 0 kPa or more, but usually 0.01 kPa or more. By pressing the resin sheet under this high level of vacuum degree, formation of the void can be suppressed.

The pressing of the resin sheet at the step (II) is performed under a particular heating condition. Usually, by controlling the temperature of the rigid plate at the particular temperature, the temperature of the resin sheet in contact with the rigid plate is controlled at the particular temperature. The range of the temperature of the heating condition is usually 80°C or higher, preferably 85°C or higher, and more preferably 90°C or higher, and is preferably 160°C or lower, more preferably 155°C or lower, and especially preferably 150°C or lower. When the pressing is performed under such heating condition, the fluidity of the resin composition contained in the resin composition layer can be increased to cause smooth entry of the resin composition into the first through hole.

The pressure condition applied to the resin sheet with the rigid plate at the step (II) is not restricted as long as the resin composition can fill the first through hole. From the viewpoint of particularly smooth filling of the first through hole with the resin composition, the pressure condition is preferably 5 kgf/cm$^2$ or more, more preferably 7 kgf/cm$^2$ or more, and especially preferably 10 kgf/cm$^2$ or more. In general, the resin composition containing the magnetic powder is prone to have a low fluidity, thus it is preferable to perform the pressing with a large pressure condition as described above. The upper limit of the pressure condition may be, for example, 100 kgf/cm$^2$ or less, 70 kgf/cm$^2$ or less, or 50 kgf/cm$^2$ or less.

The period during which the rigid plate presses the resin sheet at the step (II) is not restricted as long as the resin composition can fill the first through hole. Specifically, the pressing period is preferably 10 seconds or longer, more preferably 20 seconds or longer, and especially preferably 30 seconds or longer, and is preferably 30 minutes or shorter, more preferably 20 minutes or shorter, and especially preferably 10 minutes or shorter, although this range may vary depending on the composition of the resin composition and the size of the first through hole.

When the step (I) includes placing the resin sheet on both sides of the core substrate, the step (II) includes pressing at least one of these resin sheets. From the viewpoint of more surely suppressing the formation of the unfilled portion, the step (II) preferably includes pressing both the resin sheets placed on both sides of the core substrate by means of the rigid plate.

In the step (II), the first through hole in the core substrate can be filled with the resin composition. With this, formation of the unfilled portion as the vacant space not having the resin composition in the first through hole can be suppressed. In addition, formation of the void in the resin composition in the first through hole can be suppressed. Therefore, according to the step (II), with a superior filling performance, the first through hole can be filled with the resin composition.

Usually, a part of the resin composition contained in the resin composition layer fills the first through hole. Therefore, a rest part of the resin composition contained in the resin composition layer does not enter the first through hole; thus, this may adhere onto the main surface of the core substrate thereby forming a layer.

Usually, the support of the resin sheet is removed after the step (II). The removal of the support may be performed before the step (III) or after the step (III), which is going to be described below.

<Step (III)>

The production method for the magnetic substrate according to one embodiment of the present invention may include, after the step (II), a step (III) of curing the resin composition. By curing the resin composition, a cured product of the resin composition can be formed. Therefore, the magnetic substrate including the cured product of the resin composition can be obtained.

The curing of the resin composition is usually performed by a thermal curing. Conditions of the thermal curing of the resin composition may be set as appropriate as long as the curing of the resin composition can proceed. The curing temperature is preferably 60°C or higher, more preferably 70°C or higher, and still more preferably 80°C or higher, and is preferably 245°C or lower, more preferably 220°C or lower, and still more preferably 200°C or lower. The curing period is preferably 5 minutes or longer, more preferably 10 minutes or longer, and still more preferably 15 minutes or longer, and is preferably 120 minutes or shorter, more preferably 110 minutes or shorter, and still more preferably 100 minutes or shorter.

The curing degree of the cured product that is obtained at the step (III) is preferably 80% or more, more preferably 85% or more, and still more preferably 90% or more. The curing degree can be measured by using, for example, a differential scanning calorimeter.

Usually, the cured product of the resin composition forms a cured product layer in the first through hole. Therefore, the step (III) usually includes forming the cured product layer in the first through hole. In the following description, the cured product layer formed in the first through hole may be referred to as the "filled cured product layer". The cured product of the resin composition usually forms the cured product layer also on the main surface of the core substrate. Thus, the step (III) usually includes forming the cured product layer on the main surface of the core substrate. The cured product layer formed on the main surface of the core substrate may be referred to as the "adhering cured product layer". The cured product layer such as the filled cured product layer and the adhering cured product layer are the layers that contain the cured product of the resin composition, and preferably contain only the cured product of the resin composition.

In the production method according to the present embodiment, a resin sheet that includes a thin resin composition layer can be used, so that the thickness of the adhering cured product layer can be thin. In one example, the range of the thickness of the adhering cured product layer before the step (IV) to be described later may be preferably 100 $\mu$m or less, more preferably 80 $\mu$m or less, and especially preferably 60 $\mu$m or less.

<Step (IV)>

The production method for the magnetic substrate according to one embodiment of the present invention may include, after the step (III), a step (IV) of polishing the cured product as the cured resin composition. Usually, it is preferable to remove the adhering cured product layer that is present outside the first through hole because it is an excess portion that is unnecessary in the product. Therefore, in the step (IV), the adhering cured product layer is preferably polished to be removed. In the step (IV), at the same time with the adhering cured product layer on the main surface of the core substrate, a part of the filled cured product layer in the first through hole as well as a part of the core substrate may be polished.

Illustrative examples of the polishing method may include a buff polishing, a belt polishing, and a ceramic polishing. Illustrative examples of the buff polishing equipment that is commercially available may include "NT-700IM" manufactured by Ishiihyoki Co., Ltd.

Usually, by polishing, a flat polished surface can be formed on the surface of the filled cured product layer. From the viewpoint of forming the conductive layer on the polished surface with a high adhesion property, the arithmetic average roughness (Ra) of this polished surface is preferably 100 nm or more, more preferably 150 nm or more, and still more preferably 200 nm or more, and is preferably 1000 nm or less, more preferably 900 nm or less, and still more preferably 800 nm or less. The surface roughness (Ra) can be measured, for example, by using a non-contact type surface roughness meter.

Usually, the polished surface of the filled cured product layer formed by polishing is flush with the main surface of the core substrate. Here, a certain surface is "flush" with another surface means that these surfaces form a single flat plane. Thus, the main surface of the core substrate and the polished surface of the filled cured product layer may form a smooth flat plane. A conductor layer may be formed on this smooth flat plane at the step (VI).

<Step (V)>

The production method for the magnetic substrate according to one embodiment of the present invention may include, after the step (III), a step (V) of forming a through hole in the filled cured product layer in the first through hole. When the production method for the magnetic substrate includes the step (IV), the step (V) is usually carried out after the step (IV). Hereinafter, the above-mentioned through hole formed in the filled cured product layer may be referred to as the "second through hole". The second through hole can be formed by a known method using, for example, drilling, a laser, a plasma, or an etching media, taking into consideration the characteristics of the cured product and the size of the first through hole. The shape of the opening of the second through hole may be the same as that of the first through hole. The size of the opening of the second through hole is not particularly restricted as long as it is smaller than the size of the opening of the first through hole.

<Step (VI)>

The production method for the magnetic substrate according to one embodiment of the present invention may include, after the step (III), a step (VI) of forming a conductor layer. When the production method for the magnetic substrate includes the step (IV), the step (VI) is usually carried out after the step (IV). When the production method for the magnetic substrate includes the step (V), the step (VI) may be carried out to form the conductor layer on the wall of the second through hole after the step (V)

The conductor layer is usually formed on the cured product layer. When the adhering cured product layer is removed at the step (IV), it is preferable to form the conductor layer on the filled cured product layer. The conductor layer may be formed on the core substrate. In one example, the conductor layer is formed on the polished surface of the filled cured product layer and on the main surface of the core substrate. The conductor layer may be formed on one or both sides of the magnetic substrate. The conductor layer may be formed on the wall surface of the second through hole formed at the step (V).

The conductor layer may be formed of a conductor. Illustrative examples of the conductor may include: single metals such as gold, platinum, palladium, silver, copper, aluminum, cobalt, chromium, zinc, nickel, titanium, tungsten, iron, tin, and indium; and alloys of two or more metals selected from the group consisting of gold, platinum, palladium, silver, copper, aluminum, cobalt, chromium, zinc, nickel, titanium, tungsten, iron, tin, and indium. Among these, from the viewpoints of general applicability, cost, easiness in patterning, and the like, preferably usable are chromium, nickel, titanium, aluminum, zinc, gold, palladium, silver, and copper, as well as a nickel-chromium alloy, a copper-nickel alloy, and a copper-titanium alloy. More preferable are chromium, nickel, titanium, aluminum, zinc, gold, palladium, silver, and copper, as well as the nickel-chromium alloy. Copper is still more preferably used.

The thickness of the conductor layer is preferably 1 $\mu$m or more, more preferably 3 $\mu$m or more, and still more preferably 5 $\mu$m or more, and is preferably 70 $\mu$m or less, more preferably 50 $\mu$m or less, still more preferably 40 $\mu$m or less, and especially preferably 30 $\mu$m or less.

The conductor layer may be formed by the forming method such as a plating method, a sputtering method, and a vapor deposition method, for example. Among these, a plating method is preferable. A part of the formed conductor layer may be removed by removing process such as etching to obtain a patterned conductor layer having an intended planar shape. The planar shape refers to the shape viewed from a thickness direction, unless otherwise specifically mentioned. In a preferable embodiment, the patterned conductor layer having an intended wiring pattern may be formed by plating using an appropriate method such as a semi-additive method and a full additive method. When a part of the conductor layer is removed by removing process such as etching, a part of the conductor layer included in the core substrate may be removed. For example, an inductor element may be obtained in the magnetic substrate by forming a coil-shaped wiring by the conductor layer, which is formed on the cured product layer and on the core substrate, and the conductor layer possessed by the core substrate inside of it.

Hereinafter, examples of the method for forming the patterned conductor layer will be described in detail. A plating seed layer is formed on the cured product layer by an electroless plating. Next, after a mask pattern is formed as needed, an electroplated layer is formed on the resulting plating seed layer by an electroplating. Then, as needed, the mask pattern is removed, and then further an unnecessary plating seed layer is removed by a treatment such as etching, so that the patterned conductor layer having an intended wiring pattern can be formed. After the patterned conductor layer is formed, in order to improve the adhesion strength of the patterned conductor layer, an annealing treatment may be carried out, as needed. The annealing treatment can be carried out, for example, by heating at the temperature range of 150°C to 200°C for the period of 20 minutes to 90 minutes.

<Advantages of the production method for the magnetic substrate>

By the production method described above, it is possible to obtain the magnetic substrate including the cured product layer formed of the cured product of the resin composition containing the magnetic powder. In the magnetic substrate obtained by the above-mentioned production method, the formation of the unfilled portion as a vacant portion not having the cured product and the void as an air bubble in the cured product can be suppressed in the first through hole of the core substrate.

In the production method described above, not only the resin composition present on the opening of the first through hole but also the resin composition present around the opening can be filled into the first through hole. Therefore, even when the resin sheet including a thin resin composition layer is used, the first through hole can be filled with the resin composition.

Moreover, when the resin composition layer is thin as described above, the thickness of the adhering cured product layer formed on the main surface of the core substrate can be reduced. Therefore, the time required to remove the adhering cured product layer by polishing can be shortened. Accordingly, the production time of the magnetic substrate can be shortened.

According to the magnetic substrate thereby produced, an inductor component including the magnetic substrate described above can be produced. For example, when a coil-shaped wiring is formed of the conductor layer in at least one portion around the filled cured product layer, an inductor component including an inductor pattern containing the wiring can be obtained. As for the inductor component, for example, the one that is described in Japanese Patent Application Laid-open No. 2016-197624 may be applied.

The magnetic substrate can be used as the wiring board to mount an electronic component such as a semiconductor chip, and can also be used as a (multilayered) printed wiring board that uses this wiring board as an inner layer substrate. In addition, the magnetic substrate can be used as a chip inductor component obtained by dicing the wiring board, and can also be used as a printed wiring board in which the chip inductor component is surface-mounted. In addition, by using this wiring board, semiconductor devices with various aspects can be produced. The semiconductor device including the wiring board can be suitably used in electric products (for example, a computer, a mobile phone, a digital camera, and a television), vehicles (for example, a motor bike, an automobile, a train, a marine ship, and an airplane), and so forth.

<Optional step (VII)>

The production method for the magnetic substrate according to one embodiment of the present invention may further include an optional step in combination with the steps described above. For example, the production method for the magnetic substrate may include, between the step (I) and the step (II), a step (VII) of pressing the resin sheet with an elastic member.

For example, there is a 2-chamber laminator that includes a first chamber provided with an elastic member capable of pressing the resin sheet and a second chamber provided with a rigid plate capable of pressing the resin sheet. Examples of such a 2-chamber laminator may include a rubber press type laminator "CVP-700" manufactured by Nikko-Materials Co., Ltd. and a diaphragm type laminator "MVLP-500/600IIB" manufactured by Meiki Co., Ltd. When using the 2-chamber laminator described above, the pressing at the step (II) described earlier may be performed in the second chamber. In such a case, before the step (II), the step (VII) of pressing the resin sheet with the elastic member in the first chamber may be carried out.

At the step (VII), the resin sheet is pressed by means of the elastic member to fill the first through hole in the core substrate with the resin composition contained in the resin composition layer. However, the resin composition does not necessarily have to fill the entire first through hole at the step (VII) because further pressing at the step (II) is carried out after the step (VII).

As the elastic member, a rubber plate or a rubber sheet is usually used. The elastic member may be arranged on the rigid plate, so that the resin sheet may be pressed with the elastic member. The pressing of the resin sheet at the step (VII) is performed in such a way that the elastic member is in contact with the resin sheet. The term "elastic member in contact with the resin sheet" means that there is no optional layer between the elastic member and the resin sheet.

It is preferable that the pressing of the resin sheet at the step (VII) is performed in the particular range of the vacuum degree described in the step (II). When the resin sheet is pressed in such a high level of vacuum degree, the formation of the void can be effectively suppressed.

The pressing of the resin sheet at the step (VII) is performed preferably in the particular heating condition described in the step (II). When the pressing is performed under these heating condition, the resin composition can enter the first through hole especially smoothly.

The pressing of the resin sheet at the step (VII) may be performed under the pressure condition described in the step (II). The pressing of the resin sheet at the step (VII) may be performed for the period described in the step (II). Moreover, when the step (I) includes placing the resin sheets on both sides of the core substrate, the step (VII) may include pressing both resin sheets placed on both sides of the core substrate with the elastic member.

<Optional step (VIII)>

The production method for the magnetic substrate according to one embodiment of the present invention may include, between the step (II) and the step (III), a step (VIII) of heating the resin composition layer at a temperature lower than the curing temperature, as an optional step. Hereinafter, this heating at the step (VIII) may be referred to as "preheating". For example, prior to curing of the resin composition layer at the step (III), the resin composition layer may be preheated usually at a temperature of 50°C or higher and lower than 120°C (preferably 60°C or higher and 110°C or lower, more preferably 70°C or higher and 100°C or lower), and usually for the period of 5 minutes or longer (preferably for 5 minutes to for 150 minutes, more preferably for 15 minutes to for 120 minutes).

<Step (IX)>

The production method for the magnetic substrate according to one embodiment of the present invention may include, between the step (III) and the step (IV), a step (IX) of subjecting the cured product layer to a heat treatment in order to further increase the curing degree of the cured product layer, as an optional step. As for the temperature at this heat treatment, the aforementioned curing temperature to cure the resin composition may be applied. Specifically, the heat treatment temperature is preferably 120°C or higher, more preferably 130°C or higher, and still more preferably 150°C or higher, and is preferably 245°C or lower, more preferably 220°C or lower, and still more preferably 200°C or lower. The heat treatment period is preferably 5 minutes or longer, more preferably 10 minutes or longer, and still more preferably 15 minutes or longer, and is preferably 150 minutes or shorter, more preferably 120 minutes or shorter, and still more preferably 100 minutes or shorter.

<Step (X)>

The production method for the magnetic substrate according to one embodiment of the present invention may include, after the step (III), a step (X) of subjecting the surface of the cured product layer to a roughening treatment, as an optional step. The step (X) is usually performed after the step (IV). The step (X) is usually performed before the step (VI). At the step (X), not only the surface of the cured product layer but also the main surface of the core substrate may be subjected to the roughening treatment. Because the surface roughness of the treated surface can be increased by the roughening treatment, the adhesion strength of the conductor layer to be formed on the treated surface can be increased.

The procedure and condition of the roughening treatment are not particularly restricted; for example, the procedure and condition that are used in the production method for a multilayer printed wiring board may be used. In a specific example, the roughening treatment may be carried out by the method including a swelling treatment with a swelling liquid, a roughening treatment with an oxidant, and a neutralizing treatment with a neutralizing solution in this order.

Illustrative examples of the swelling liquid that can be used in the swelling treatment may include an alkaline solution and a surfactant solution; here, the alkaline solution is preferable. As for the alkaline solution as the swelling liquid, a sodium hydroxide solution and a potassium hydroxide solution are more preferable. Illustrative examples of the swelling liquid that is commercially available may include "Swelling Dip Securiganth P" and "Swelling Dip Securiganth SBU", which are both manufactured by Atotech Japan K. K. The swelling treatment with the swelling liquid can be carried out, for example, by immersing the cured product layer into the swelling liquid at the temperature of 30°C to 90°C for the period of 1 minute to 20 minutes. From the viewpoint of suppressing the swelling of the resin that is contained in the cured product layer to a suitable level, it is preferable that the cured product layer is immersed into the swelling liquid at the temperature of 40°C to 80°C for the period of 5 minutes to 15 minutes.

Illustrative examples of the oxidant that can be used in the roughening treatment may include an alkaline permanganate solution having potassium permanganate or sodium permanganate dissolved into a sodium hydroxide aqueous solution. The roughening treatment using the oxidant such as the alkaline permanganate solution is preferably carried out by immersing the cured product layer into the oxidant solution heated at 60°C to 80°C for the period of 10 minutes to 30 minutes. The concentration of the permanganate salt in the alkaline permanganate solution is preferably in the range of 5% by mass to 10% by mass. Illustrative examples of the oxidant that is commercially available may include alkaline permanganate solutions such as "Concentrate Compact P" and "Dosing Solution Securiganth P", both of which are manufactured by Atotech Japan K. K.

The neutralizing solution that may be used in the neutralizing treatment is preferably an acidic aqueous solution. A commercially available neutralizing solution is, for example, "Reduction Solution Securigance P" manufactured by Atotech Japan K. K. The neutralizing treatment with the neutralizing solution can be conducted by immersing the treated surface, which has been subjected to the roughening treatment using the oxidant solution, into the neutralizing solution at the temperature range of 30°C to 80°C for the period of 5 minutes to 30 minutes. From the viewpoint of workability, it is preferable to immerse the cured product layer, which has been subjected to the roughening treatment using the oxidant solution, into the neutralizing solution at the temperature range of 40°C to 70°C for the period of 5 minutes to 20 minutes.

From the viewpoint of enhancing the adhesion property with the conductor layer, the arithmetic average roughness (Ra) of the surface of the cured product layer after the roughening treatment is preferably 300 nm or more, more preferably 350 nm or more, and still more preferably 400 nm or more. The upper limit thereof is preferably 1500 nm or less, more preferably 1200 nm or less, and still more preferably 1000 nm or less. The surface roughness (Ra) can be measured, for example, by using a non-contact type surface roughness meter.

<First specific example of the production method>

Hereinafter, a first specific example of the production method for the magnetic substrate will be explained with referring to the drawings.

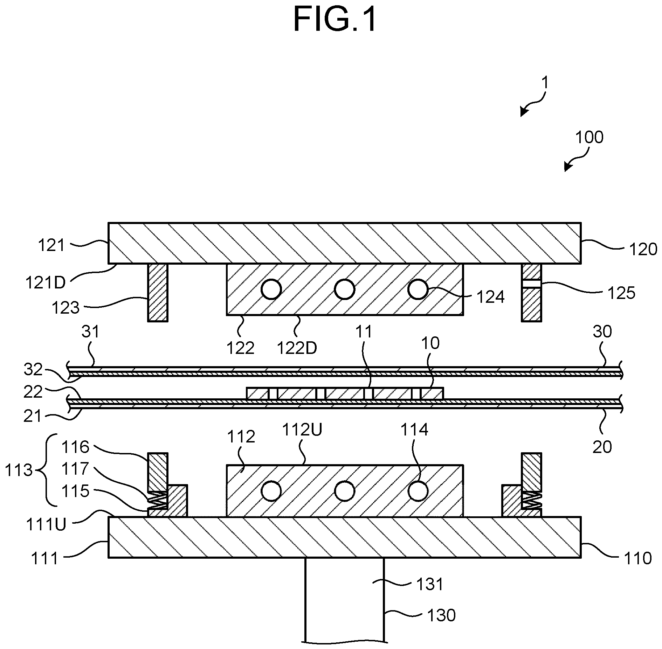

FIG. 1 is a schematic cross sectional view illustrating a laminator 1 used in the production method according to the first specific example of the present invention. As shown in FIG. 1, the first specific example describes the production method that uses a core substrate 10 formed with a first through hole 11, a resin sheet 20 including a support 21 and a resin composition layer 22, and a resin sheet 30 including a support 31 and a resin composition layer 32. The core substrate 10 may contain a conductor layer (not illustrated in the drawing) on its surface and inside thereof.

The laminator 1 as the production equipment used in the production method according to the first specific example of the present invention includes a stage 100 for filling the first through hole 11 in the core substrate 10 with the resin composition, as illustrated in FIG. 1. The stage 100 includes a lower pressing member 110 as a first pressing member, an upper pressing member 120 as a second pressing member that is arranged opposite to the lower pressing member 110, and a hydraulic cylinder 130 as a driving unit. The hydraulic cylinder 130 is provided with a piston rod 131 that is extendible and retractable, so that the piston rod 131 can be extended and retracted by a hydraulic pressure.

The lower pressing member 110 includes a lower supporting member 111, a lower plate 112 as the rigid plate, and a lower frame member 113.

The lower supporting member 111 is installed movably back and forth relative to the upper pressing member 120. The lower supporting member 111 has a supporting surface 111U facing the upper pressing member 120. The lower supporting member 111 is connected to the hydraulic cylinder 130 so that the lower plate 112 can press the core substrate 10, the resin sheet 20, and the resin sheet 30, which are placed between the lower pressing member 110 and the upper pressing member 120. The following explanation illustrates an example in which the lower supporting member 111 rises closer to the upper pressing member 120 when the piston rod 131 of the hydraulic cylinder 130 is extended, and the lower supporting member 111 descends away from the upper pressing member 120 when the piston rod 131 is retracted.

The lower plate 112 is a flat plate arranged on the supporting surface 111U of the lower supporting member 111. The lower plate 112 is formed of a rigid material. The lower plate 112 has a pressing surface 112U as the flat surface facing the upper pressing member 120. In the lower plate 112, a heater 114 is arranged so that the lower plate 112 can be heated. The lower plate 112 may be arranged in contact with the supporting surface 111U of the lower supporting member 111, or it may be arranged via an optional member. Here, an example of the lower plate 112 arranged on the supporting surface 111U via an insulation material and a cushioning material, which are not illustrated in the drawing, is illustrated and explained.

The lower frame member 113 is arranged hermetically on the supporting surface 111U of the lower supporting member 111 so as to surround the lower plate 112. The lower frame member 113 is arranged to be capable of forming a vacuum frame together with an upper frame member 123 when joined with the upper frame member 123 included in the upper pressing member 120. Here, the explanation describes an example in which the lower frame member 113 includes a fixed frame portion 115 hermetically fixed onto the supporting surface 111U, a movable frame portion 116 arranged slidably relative to the fixed frame portion 115, and an elastic supporting portion 117, such as a spring, that supports the movable frame portion 116 so as to push it up toward the upper pressing member 120. A space between the fixed frame portion 115 and the movable frame portion 116 is sealed by a sealing material not illustrated, so that the movable frame portion 116 can slide freely while keeping the hermetical state.

The upper pressing member 120 includes an upper supporting member 121, an upper plate 122 as the rigid plate, and the upper frame member 123.

The upper supporting member 121 is installed movably back and forth relative to the lower pressing member 110. The upper supporting member 121 has a supporting surface 121D facing the lower pressing member 110. Here, the explanation describes an example where the lower pressing member 110 is arranged movable by driving the hydraulic cylinder 130 as described above, and the upper pressing member 120 is fixed in its position. In this example, the upper pressing member 120 can move relative to the lower pressing member 110 as the lower pressing member 110 moves, and thus the upper plate 122 can press the core substrate 10, the resin sheet 20, and the resin sheet 30, which are placed between the lower pressing member 110 and the upper pressing member 120.

The upper plate 122 is a flat plate arranged on the supporting surface 121D of the upper supporting member 121. The upper plate 122 is formed of a rigid material. The upper plate 122 has a pressing surface 122D as the flat surface facing the lower pressing member 110. In the upper plate 122, a heater 124 is arranged so that the upper plate 122 can be heated. The upper plate 122 may be arranged in contact with the supporting surface 121D of the upper supporting member 121, or it may be arranged via an optional member. Here, an example of the upper plate 122 arranged on the supporting surface 121D via an insulation material and a cushioning material, which are not illustrated in the drawing, is illustrated and explained.

The upper frame member 123 is hermetically arranged on the supporting surface 121D of the upper supporting member 121 so as to surround the upper plate 122. This upper frame member 123 is arranged to be capable of forming a vacuum frame together with the lower frame member 113 when joined with the lower frame member 113 included in the lower pressing member 110. The upper frame member 123 is provided with a nozzle 125, and a pressure controlling device (not illustrated in the drawing) such as a vacuum pump is connected to this nozzle 125.

When using the laminator 1 described above to perform the production method according to the first specific example, the magnetic substrate can be produced using the following method. Here, an example of placing the resin sheet 20 on one side of the core substrate 10 and the resin sheet 30 on the other side of the core substrate 10 is illustrated and explained.

In the production method according to the first specific example, the core substrate 10, the resin sheet 20, and the resin sheet 30 are supplied into between the lower pressing member 110 and the upper pressing member 120 in the stage 100. For example, the long-length resin sheets 20 and 30 are conveyed through the conveying path between the lower pressing member 110 and the upper pressing member 120. At this time, by conveying the resin sheet 20 having the core substrate 10 placed on the lower resin sheet 20, the core substrate 10 may be supplied into between the lower pressing member 110 and the upper pressing member 120.

The hydraulic cylinder 130 is then driven to extend the piston rod 131. As the piston rod 131 extends, the lower pressing member 110 rises and approaches the upper pressing member 120. When the lower pressing member 110 rises, the upper frame member 123 contacts the movable frame portion 116 of the lower frame member 113 and pushes the movable frame portion 116. Accordingly, the space between the lower frame member 113 and the upper frame member 123 is closed thereby forming an enclosed space surrounded by the lower supporting member 111, the upper supporting member 121, the lower frame member 113, and the upper frame member 123. The pressure controlling device (not illustrated in the drawing) then evacuates this enclosed space through the nozzle 125. Because of the evacuation, the environment inside the enclosed space becomes a vacuum state having a particular range of the vacuum degree.

As the lower pressing member 110 rises, the pressing surface 112U of the lower plate 112 eventually contacts the resin sheet 20 and pushes the resin sheet 20 up. The pressing surface 122D of the upper plate 122 contacts the resin sheet 30 and pushes the resin sheet 30 down. Accordingly, the resin composition layer 22 of the resin sheet 20 contacts one side of the core substrate 10 and the resin composition layer 32 of the resin sheet 30 contacts the other side of the core substrate 10. Therefore, the resin sheets 20 and 30 are placed on both sides of the core substrate 10 (step (I)).

After the resin sheets 20 and 30 are placed on both sides of the core substrate 10, the resin composition is filled into the first through hole 11 (step (II)). Here, an example is illustrated and explained in which the resin sheet 20 is pressed by the lower plate 112 to fill the first through hole 11 with the resin composition contained in the resin composition layer 22, and the resin sheet 30 is pressed by the upper plate 122 to fill the first through hole 11 with the resin composition contained in the resin composition layer 32.

Specifically, this is conducted as follows. After the enclosed space that accommodates the core substrate 10, the resin sheet 20, and the resin sheet 30 is made to a vacuum state, the hydraulic cylinder 130 further raises the lower pressing member 110. As the lower pressing member 110 rises, the lower plate 112 in contact with the resin sheet 20 presses the resin sheet 20, so that the resin composition in the resin composition layer 22 fills the first through hole 11. The upper plate 122 in contact with the resin sheet 30 presses the resin sheet 30, so that the resin composition in the resin composition layer 32 fills the first through hole 11. In this case, the temperature of the lower plate 112 and the upper plate 122 is adjusted by the heaters 114 and 124 to control the temperature condition during the pressing in the particular range described before. This pressing causes the first through hole 11 to be filled with the resin composition. When employing the conditions described in the aforementioned embodiment, the formation of the void and the unfilled portion can be suppressed, thereby achieving a superior filling performance.

After the resin composition is filled in the first through hole 11, the vacuum state in the enclosed space is released through the nozzle 125, and the piston rod 131 is retracted to lower the lower pressing member 110. The core substrate 10 filled with the resin composition is then provided to the next step.

Usually, after the resin composition is filled in the first through hole 11, the resin composition is cured (step (III)). For example, the resin composition is thermally cured to obtain the cured product.

The production method for the magnetic substrates may also include the step of removing the supports 21 and 31 after filling the first through hole 11 with the resin composition. The supports 21 and 31 may be removed before or after curing the resin composition.

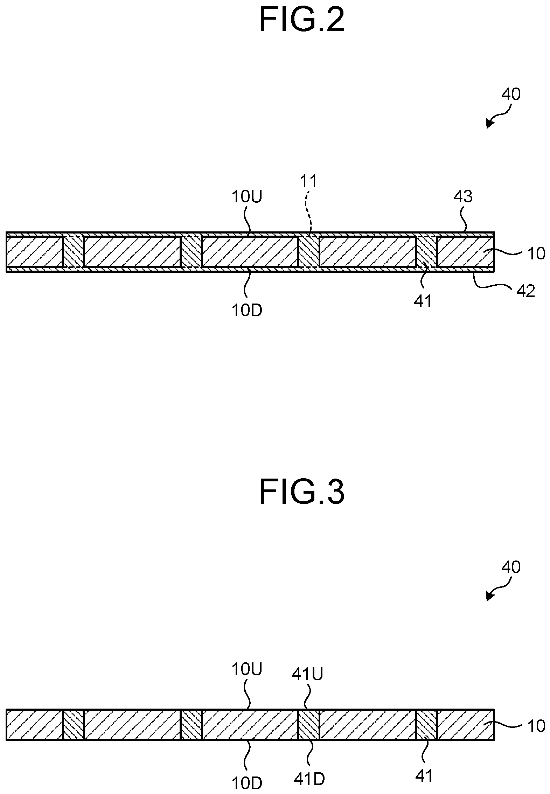

FIG. 2 is a schematic cross sectional view illustrating a magnetic substrate 40 obtained by the production method according to the first specific example of the present invention. As shown in FIG. 2, by curing the resin composition, the magnetic substrate 40 including the core substrate 10 and the cured product of the resin composition that is filled in the first through hole 11 of the core substrate 10 can be obtained. The magnetic substrate 40 includes a filled cured product layer 41 as a layer of the cured product formed in the first through hole 11. In the production method using the resin sheets 20 and 30 as described earlier, the resin composition may adhere onto main surfaces 10D and 10U of the core substrate 10, so that the magnetic substrate 40 may include adhering cured product layers 42 and 43 on the main surfaces 10D and 10U of the core substrate 10.

In many cases, the adhering cured product layers 42 and 43 are not necessary in the final product. Therefore, after curing the resin composition, the production method for the magnetic substrate may include polishing the cured product as the cured resin composition (step (IV)). Preferably, the adhering cured product layers 42 and 43 are removed by polishing.

FIG. 3 is a schematic cross sectional view illustrating the magnetic substrate 40 obtained by the production method according to the first specific example of the present invention. As shown in FIG. 3, when the adhering cured product layers 42 and 43 are polished to be removed, the magnetic substrate 40 including the core substrate 10 and the filled cured product layer 41 can be obtained. After polishing, a surface 41D of the filled cured product layer 41 is usually flush with the main surface 10D of the core substrate 10. A surface 41U of the filled cured product layer 41 after polishing is usually flush with the main surface 10U of the core substrate 10.

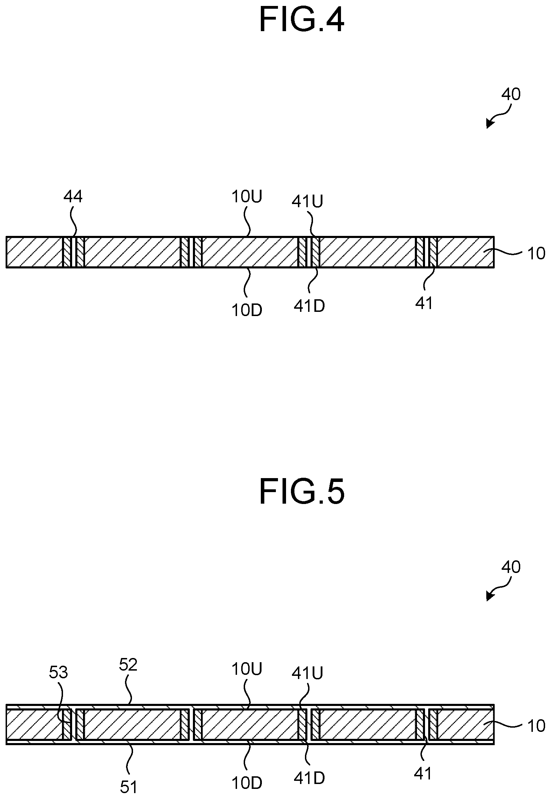

FIG. 4 is a schematic cross sectional view illustrating the magnetic substrate 40 obtained by the production method according to the first specific example of the present invention. After curing of the resin composition, the production method for the magnetic substrate may form a second through hole 44 in the filled cured product layer 41 formed in the first through hole 11 (step (V)), as illustrated in FIG. 4.

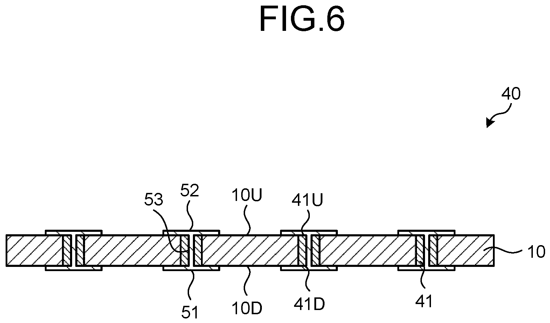

FIGS. 5 and 6 are both cross sectional views schematically illustrating the magnetic substrate 40 obtained by the production method according to the first specific example of the present invention. The production method for the magnetic substrate may include forming conductor layers 51 to 53 after curing the resin composition, as shown in FIG. 5 (step (VI)). FIG. 5 illustrates an example in which the conductor layer 51 is formed on the surface 41D of the filled cured product layer 41 and on the main surface 10D of the core substrate 10, the conductor layer 52 is formed on the surface 41U of the filled cured product layer 41 and on the main surface 10U of the core substrate 10, and the conductor layer 53 is formed in the second through hole 44. However, there is no restriction in the locations where the conductor layers 51 to 53 are formed. Therefore, the conductor layers 51 to 53 may be formed on the surfaces 41D and 41U of the filled cured product layer 41, or on the main surfaces 10D and 10U of the core substrate 10, or in the second through hole 44, or in some or all of them. In the production method for the magnetic substrate, the conductor layers 51 to 53 may be subjected to pattern processing as illustrated in FIG. 6 by processing method such as etching. By forming and processing the conductor layers 51 to 53 described above, the magnetic substrate 40 including the conductor layers 51 to 53 having an intended pattern shape can be obtained. When the conductor layers 51 to 53 form a coiled inductor pattern, it is possible to obtain, as the aforementioned magnetic substrate 40, an inductor component in which the filled cured product layer 41 can function as the core. The conductor layers 51 to 53 may be combined with a conductor layer (not illustrated in the drawing) included in the core substrate 10 to form an inductor pattern.

<Second specific example of the production method>

The production method for the magnetic substrate described above may include the step (VII) of pressing the resin sheet with an elastic member before the step (II) of pressing the resin sheet with a rigid plate to fill the first through hole with the resin composition. Hereinafter, a second specific example according to the production method including this step (VII) will be described.

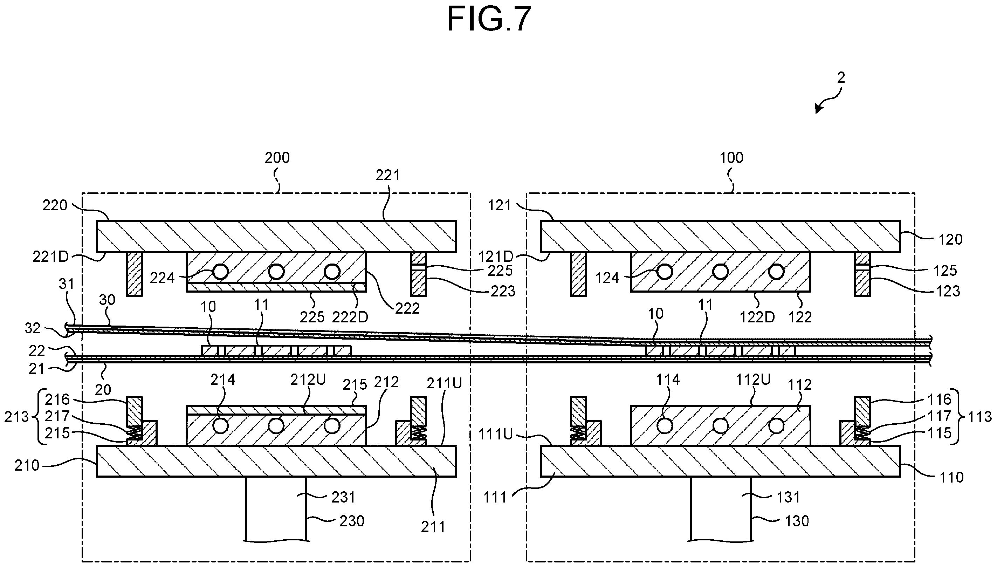

FIG. 7 illustrates a schematic cross sectional view illustrating a laminator 2 used in the production method according to the second specific example of the present invention. As shown in FIG. 7, a laminator 2 as the production equipment used in the production method according to the second specific example of the present invention is arranged in the same manner as the laminator 1 used in the production method according to the first specific example, except that the laminator 2 includes a stage 200 in combination with the stage 100. In the following explanation, the stage 100 may be referred to as a "hot press stage" 100 and the stage 200 as a "press-adhering stage" 200 for the sake of distinction. The hot press stage 100 has been described in the first specific example.

In the press-adhering stage 200, an elastic member 215 is arranged on a pressing surface 212U of a lower plate 212 so that the resin sheet 20 can be pressed by means of the elastic member 215 such as a rubber sheet. In the press-adhering stage 200, an elastic member 225 is arranged on a pressing surface 222D of an upper plate 222 so that the resin sheet 30 can be pressed by means of the elastic member 225. Except that the elastic members 215 and 225 are arranged as described above, the press-adhering stage 200 is arranged in the same manner as the hot press stage 100.

Accordingly, the press-adhering stage 200 includes a lower pressing member 210 as a third pressing member, an upper pressing member 220 as a fourth pressing member that is arranged opposite to the lower pressing member 210, and a hydraulic cylinder 230 as a driving device. The hydraulic cylinder 230 is arranged in the same manner as the hydraulic cylinder 130 in the hot press stage 100 and includes a piston rod 231 that is the same as the piston rod 131.

The lower pressing member 210 includes a lower supporting member 211, the lower plate 212, a lower frame member 213, and the elastic member 215 arranged on the pressing surface 212U of the lower plate 212. The lower supporting member 211, the lower plate 212, and the lower frame member 213 are arranged in the same manner as the lower supporting member 111, the lower plate 112, and the lower frame member 113. Accordingly, the lower supporting member 211 is arranged movably back and forth relative to the upper pressing member 220 and has a supporting surface 211U that faces the upper pressing member 220. The lower plate 212 has the pressing surface 212U that faces the upper pressing member 220, and also has a heater 214 so that the pressing temperature can be controlled. The lower frame member 213 includes a fixed frame portion 215, a movable frame portion 216, and an elastic supporting portion 217 that are arranged in the same manner as the fixed frame portion 115, the movable frame portion 116, and the elastic supporting portion 117 so as to form a vacuum frame together with an upper frame member 223 when joined with the upper frame member 223 included in the upper pressing member 220. On the pressing surface 212U of the lower plate 212, the elastic member 215 such as a rubber sheet is arranged.

The upper pressing member 220 includes an upper supporting member 221, the upper plate 222, the upper frame member 223, and the elastic member 225 arranged on the pressing surface 222D of the upper plate 222. The upper supporting member 221, the upper plate 222, and the upper frame member 223 are arranged in the same manner as the upper supporting member 121, the upper plate 122, and the upper 123. Therefore, the upper supporting member 221 is arranged movably back and forth relative to the lower pressing member 210, and has a supporting surface 221D that faces the lower pressing member 210. The upper plate 222 has the pressing surface 222D that faces the lower pressing member 210, and this includes a heater 224 so that the pressing temperature can be controlled. The upper frame member 223 includes a nozzle 225; a pressure controlling device (not illustrated in the drawing) such as a vacuum pump is connected to this nozzle 225. On the pressing surface 222D of the upper plate 222, the elastic member 225 such as a rubber sheet is arranged.

When performing the production method according to the second specific example by using the laminator 2, the magnetic substrate can be produced by the following method. As in the case of the first specific example, an example in which the resin sheet 20 is placed on one side of the core substrate 10 and the resin sheet 30 is placed on the other side of the core substrate 10 is illustrated and explained here.

In the production method according to the second specific example, the core substrate 10, the resin sheet 20, and the resin sheet 30 are supplied into between the lower pressing member 210 and the upper pressing member 220 in the press-adhering stage 200. The hydraulic cylinder 230 is then driven to extend the piston rod 231 to raise the lower pressing member 210 and bring it closer to the upper pressing member 220. When the lower pressing member 210 rises, the space between the lower frame member 213 and the upper frame member 223 is closed in the same manner as the space between the lower frame member 113 and the upper frame member 123 in the first specific example, thereby forming an enclosed space surrounded by the lower supporting member 211, the upper supporting member 221, the lower frame member 213, and the upper frame member 223. The pressure controlling device (not illustrated in the drawing) then evacuates this enclosed space through the nozzle 225. Because of the evacuation, the environment inside the enclosed space becomes a vacuum state.

As the lower pressing member 210 rises, the elastic member 215 on the lower plate 212 eventually contacts the resin sheet 20 and pushes the resin sheet 20 up. The elastic member 225 on the upper plate 222 contacts the resin sheet 30 and pushes the resin sheet 30 down. Accordingly, because the resin composition layer 22 of the resin sheet 20 contacts one side of the core substrate 10 and the resin composition layer 32 of the resin sheet 30 contacts the other side of the core substrate 10, the resin sheets 20 and 30 are placed on both sides of the core substrate 10 (step (I)).

In the production method for the magnetic substrate according to the second specific example, after placing the resin sheets 20 and 30 on both sides of the core substrate 10, the resin sheets 20 and 30 are pressed with the elastic members 215 and 225 (step (VII)). In other words, the resin sheet 20 is pressed with the elastic member 215 on the lower plate 212, and the resin sheet 30 is pressed with the elastic member 225 on the upper plate 222.

Specifically, this is conducted as follows. After the enclosed space that accommodates the core substrate 10, the resin sheet 20, and the resin sheet 30 is made to a vacuum state, the hydraulic cylinder 230 further raises the lower pressing member 210. As the lower pressing member 210 rises, the elastic member 215 in contact with the resin sheet 20 presses the resin sheet 20, so that the resin composition in the resin composition layer 22 fills the first through hole 11. The elastic member 225 in contact with the resin sheet 30 presses the resin sheet 30, so that the resin composition of the resin composition layer 32 fills the first through hole 11. At this time, the temperature condition of the pressing is controlled by the heaters 214 and 224. This pressing causes the first through hole 11 to be filled with the resin composition. However, at this time point, inside of the entire first through hole 11 may not be filled by the resin composition, so that an unfilled portion (not illustrated in the drawing) may be formed in the first through hole 11.

The vacuum state in the enclosed space is then released through the nozzle 225, and the piston rod 231 is retracted to lower the lower pressing member 210. The core substrate 10 is then conveyed to the hot press stage 100.

In the hot press stage 100, the resin sheets 20 and 30 are pressed by, as the rigid plates, the lower plate 112 and the upper plate 122 to further fill the resin composition into the first through hole 11 as described in the first specific example (step (II)). Even if there is an unfilled portion in the first through hole 11 at the time when it is supplied to the hot press stage 100, the resin composition can fill the first through hole 11 while suppressing the formation of the void and the unfilled portion by pressing at the hot press stage 100, as explained in the first specific example.

The vacuum state in the enclosed space is then released through the nozzle 125, and the piston rod 131 is retracted to lower the lower pressing member 110. Then, as in the case of the first specific example, optional steps such as the curing of the resin composition (step (III)), the polishing of the cured product of the resin composition (step (IV)), the formation of the second through hole in the filled cured product layer (step (V)), and the formation of the conductor layer (step (VI)) may be performed as necessary to obtain an intended magnetic substrate.

<Other specific examples>

In the first and second specific examples described above, the nozzles 125 and 225 are arranged in the upper frame members 123 and 223, but the locations of these nozzles may be changed. For example, the nozzles may be arranged in the lower frame members 113 and 213, in the lower supporting members 111 and 211, in the upper supporting members 121 and 221, or in several of these locations.

In the first and second specific examples described above, the heaters 114, 124, 214, and 224 are arranged in the lower plates 112 and 212 and the upper plates 122 and 222 as the rigid plates, but the locations of the heaters may be changed. For example, when the rigid plate is formed of a metallic material such as a stainless steel, an energizing device may be arranged to energize the rigid plate so that the rigid plate itself can function as a heater due to the heat generated by an electrical resistance.

In the first and second specific examples described above, the hydraulic cylinders 130 and 230 are arranged as the driving devices, but the driving devices are not limited to the hydraulic cylinders 130 and 230. Examples of the driving device may include an air cylinder and a diaphragm. When a diaphragm is used, a stage that is provided with a diaphragm as a membrane that covers a hermetical space and a rigid plate that is arranged on the diaphragm via a suitable member such as an insulation material may be used. By charging a gas or a liquid into the hermetical space, the pressing can be performed by means of the rigid plate supported by the diaphragm.

Although the explanation was made with regard to the example using the 2-chamber laminator including two chambers in the second specific example described above, the production method for the magnetic substrates may be performed by using a laminator including three or more chambers and stages that are arranged in the chamber.

<Resin sheet>

The resin sheet includes a support and a resin composition layer formed on the support.

Illustrative examples of the support may include a film formed of a plastic material, metal foil, and a releasing paper. Among them, the film formed of a plastic material and metal foil are preferable.

In the case that the film formed of a plastic material is used as the support, illustrative examples of the plastic material may include: polyesters such as polyethylene terephthalate (hereinafter, this may be simply called "PET") and polyethylene naphthalate (hereinafter, this may be simply called "PEN"); polycarbonate (hereinafter, this may be simply called "PC"); acryl polymers such as polymethyl methacrylate (hereinafter, this may be simply called "PMMA"); a cyclic polyolefin; triacetyl cellulose (hereinafter, this may be simply called "TAC"); polyether sulfide (hereinafter, this may be simply called "PES"); polyether ketone; and polyimide. Among these, polyethylene terephthalate and polyethylene naphthalate are preferable; an inexpensive polyethylene terephthalate is especially preferable.

In the case that metal foil is used as the support, illustrative examples of the metal foil may include copper foil and aluminum foil. Among them, the copper foil is preferable. As for the copper foil, the foil formed of a copper single metal or the foil formed of an alloy of copper with other metal (for example, tin, chromium, silver, magnesium, nickel, zirconium, silicon, and titanium) may be used.

The support may have been subjected to a treatment such as a mat treatment, a corona treatment, and an antistatic treatment, on the surface to be bonded with the resin composition layer.

As for the support, a releasing layer-attached support including a releasing layer on the surface to be bonded with the resin composition layer may be used. The releasing agent to be used in the releasing layer of the releasing layer-attached support may be one or more releasing agents selected from the group consisting of, for example, an alkyd resin, a polyolefin resin, a urethane resin, and a silicone resin. Illustrative examples of the commercial product of the release agent may include an alkyd resin type release agent such as "SK-1", "AL-5", and "AL-7", all being manufactured by Lintech Corp. Illustrative examples of the releasing layer-attached support may include "Lumirror T60" manufactured by Toray Industries, Inc.; "PUREX" manufactured by Teijin Limited; and "UNIPEEL" manufactured by Unitika, Ltd.

The thickness of the support is not particularly restricted; the thickness is preferably 1 μm or more, more preferably 5 μm or more, and still more preferably 10 μm or more, and is preferably 75 μm or less, more preferably 60 μm or less, still more preferably 50 μm or less, and especially preferably 40 μm or less.

The resin composition layer is formed on the support. Usually, the support and the resin composition layer are directly in contact with each other without other member interposed therebetween. The resin composition layer contains a resin composition, and contains preferably only the resin composition.

The resin composition contains (A) a magnetic powder. (A) The magnetic powder as the component (A) may be a particle of the material having a relative magnetic permeability of more than 1. The material of (A) the magnetic powder is usually an inorganic material, and may be any of a soft magnetic material and a hard magnetic material. The material of (A) the magnetic powder may be used singly or in a combination of two or more of them. Therefore, (A) the magnetic powder may be any of a soft magnetic powder, a hard magnetic powder, and a combination of the soft magnetic powder and the hard magnetic powder. (A) The magnetic powder may be used singly or in a combination of two or more of them. In particular, it is preferable that (A) the magnetic powder contains a soft magnetic powder, and it is more preferable that (A) the magnetic powder contains only a soft magnetic powder.

Illustrative examples of (A) the magnetic powder may include a magnetic metal oxide powder and a magnetic metal powder.

Illustrative examples of the magnetic metal oxide powder may include ferrite powders such as a Fe-Mn type ferrite powder, a Fe-Mn-Mg type ferrite powder, a Fe-Mn-Mg-Sr type ferrite powder, a Fe-Mg-Zn type ferrite powder, a Fe-Mg-Sr type ferrite powder, a Fe-Zn-Mn type ferrite powder, a Fe-Cu-Zn type ferrite powder, a Fe-Ni-Zn type ferrite powder, a Fe-Ni-Zn-Cu type ferrite powder, a Fe-Ba-Zn type ferrite powder, a Fe-Ba-Mg type ferrite powder, a Fe-Ba-Ni type ferrite powder, a Fe-Ba-Co type ferrite powder, a Fe-Ba-Ni-Co type ferrite powder, and a Fe-Y type ferrite powder; and iron oxide powders such as an iron (III) oxide powder and a tri-iron tetroxide powder. Among these, ferrite powders are preferable. Usually, the ferrite powder is composed of a composite oxide containing an iron oxide as the main component thereof, and is chemically stable. Therefore, the ferrite powder offers advantages such as a high corrosion resistance, a low risk of ignition, and a resistance to demagnetization. Among them, ferrite powders containing at least one element selected from the group consisting of Mn and Zn are preferable, and ferrite powders containing Mn are more preferable, and a Fe-Mn type ferrite powder is especially preferable. The Fe-Mn type ferrite powder represents the ferrite powder containing Fe and Mn.

Illustrative examples of the magnetic metal powder may include a pure iron powder; and crystalline or non-crystalline alloy powders such as a Fe-Si type alloy powder, a Fe-Si-Al type alloy powder, a Fe-Cr type alloy powder, a Fe-Cr-Si type alloy powder, a Fe-Ni-Cr type alloy powder, a Fe-Cr-Al type alloy powder, a Fe-Ni type alloy powder, a Fe-Ni-Si type alloy powder, a Fe-Ni-B type alloy powder, a Fe-Ni-Mo type alloy powder, a Fe-Ni-Mo-Cu type alloy powder, a Fe-Co type alloy powder, a Fe-Ni-Co type alloy powder, and a Co-based amorphous alloy powder. Among them, the alloy powders are preferable, and the iron alloy type powders are more preferable. As for the iron alloy type powder, the iron alloy type powder containing Fe, as well as at least one element selected from the group consisting of Si, Cr, and Ni is preferable; and the Fe-Ni type alloy powder is especially preferable. The Fe-Ni type alloy powder represents the alloy powder containing Fe and Ni.

The range of the average particle diameter of (A) the magnetic powder is preferably 1 $\mu$m or more, more preferably 1.4 $\mu$m or more, and especially preferably 1.6 $\mu$m or more, and is preferably 10 $\mu$m or less, more preferably 7.5 $\mu$m or less, and especially preferably 5.0 m or less.

The average particle diameter is the median diameter on a volume basis, unless otherwise specifically mentioned. The average particle diameter can be measured with a laser diffraction scattering method based on the Mie scattering theory. Specifically, the particle diameter distribution thereof is prepared on a volume basis by using a laser diffraction scattering type particle diameter distribution analyzer, in which the median diameter thereof can be measured as the average particle diameter. The powders that are dispersed in water by means of an ultrasonic wave can be suitably used as the measurement sample. Illustrative examples of the laser diffraction scattering type particle diameter distribution analyzer that can be used include "LA-500" manufactured by Horiba Ltd. and "SALD-2200" manufactured by Shimadzu Corp.

(A) The magnetic powder may be used in a combination of two or more types of the magnetic powders having different average particle diameters. Among them, it is preferable to use a combination of (A-1) a magnetic powder having an average particle diameter of less than 1 $\mu$m and (A-2) a magnetic powder having an average particle diameter of 1 $\mu$m or more. Hereinafter, "(A-1) the magnetic powder having an average particle diameter of less than 1 $\mu$m" may be referred to as "(A-1) the small diameter magnetic powder" and "(A-2) the magnetic powder having an average particle diameter of 1 $\mu$m or more" may be referred to as "(A-2) the large diameter magnetic powder". When (A-1) the small diameter magnetic powder and (A-2) the large diameter magnetic powder are used in combination, particles of (A-1) the small diameter magnetic powder can be inserted between the particles of (A-2) the large diameter magnetic powder, so that the filling rate of (A) the magnetic powder can increase.

Specifically, the average particle diameter of (A-1) the small diameter magnetic powder is usually less than 1 $\mu$m, preferably 0.8 $\mu$m or less, and more preferably 0.6 $\mu$m or less. There is no particular restriction in the lower limit thereof; the lower limit may be 0.1 $\mu$m or more, 0.2 $\mu$m or more, or 0.3 $\mu$m or more, for example.

The amount (% by volume) of (A-1) the small diameter magnetic powder contained in the resin composition is preferably 1% by volume or more, more preferably 5% by volume or more, and especially preferably 10% by volume or more, and is preferably 50% by volume or less, more preferably 45% by volume or less, and especially preferably 40% by volume or less, relative to 100% by volume of the nonvolatile components in the resin composition. The volume content (% by volume) of each component contained in the resin composition can be determined by calculation from the mass of the component in the resin composition. Specifically, the volume of each component is obtained by dividing the mass with the specific gravity, and the volume content (% by volume) can be calculated from the volume of each component obtained.

Specifically, the average particle diameter of (A-2) the large diameter magnetic powder is usually 1 $\mu$m or more, preferably 2 $\mu$m or more, and more preferably 3 $\mu$m or more. The upper limit thereof is not particularly restricted; for example, the upper limit may be 20 $\mu$m or less, more preferably 15 $\mu$m or less, and especially preferably 10 m or less, for example.

It is preferable that the amount (% by volume) of (A-2) the large diameter magnetic powder is more than the amount (% by volume) of (A-1) the small diameter magnetic powder. The specific amount (% by volume) of (A-2) the large diameter magnetic powder contained in the resin composition is preferably 10% by volume or more, more preferably 20% by volume or more, and especially preferably 30% by volume or more, and is preferably 80% by volume or less, more preferably 70% by volume or less, and especially preferably 60% by volume or less, relative to 100% by volume of the nonvolatile components in the resin composition.

From the viewpoint of increasing a relative magnetic permeability, the specific surface area of (A) the magnetic powder is preferably 0.05 m$^2$/g or more, more preferably 0.1 m$^2$/g or more, and still more preferably 0.3 m$^2$/g or more, and is preferably 10 m$^2$/g or less, more preferably 8 m$^2$/g or less, and still more preferably 5 m$^2$/g or less. The specific surface area of (A) the magnetic powder can be measured by the BET method. Specifically, the specific surface area can be measured according to the BET method by adsorbing a nitrogen gas onto the sample surface using a specific surface area measurement instrument ("Macsorb HM Model 1210" manufactured by Mountech Co., Ltd.) with the BET multipoint method.

The particle of (A) the magnetic powder is preferably spherical or ellipsoidal. The ratio (aspect ratio) that is obtained by dividing the length of the longitude axis by the length of the short axis of the particles of (A) the magnetic powder is preferably 2 or less, more preferably 1.5 or less, and still more preferably 1.2 or less, and this is usually 1.0 or more. In general, when the particle shape of the magnetic powder is not a spherical shape but a flat shape, a relative magnetic permeability can be increased readily. On the other hand, when the particle shape of the magnetic powder is close to a spherical shape, the magnetic loss tends to be decreased.

The true specific gravity of (A) the magnetic powder may be, for example, 4 g/cm$^3$ to 10 g/cm$^3$.

The amount (% by volume) of (A) the magnetic powder contained in the resin composition is preferably 65% by volume or more, more preferably 67% by volume or more, and especially preferably 70% by volume or more, and is preferably 95% by volume or less, more preferably 90% by volume or less, and especially preferably 85% by volume or less, relative to 100% by volume of the nonvolatile components in the resin composition. When using the resin composition that contains a large amount of (A) the magnetic powder as described above, it has been difficult to fill the first through hole with the resin composition with a conventional method, but with the method according to the embodiment described above, the first through hole can be filled with the resin composition with a superior filling performance.

The amount (% by mass) of (A) the magnetic powder contained in the resin composition is preferably 75% by mass or more, more preferably 80% by mass or more, and especially preferably 85% by mass or more, and is preferably 99% by mass or less, more preferably 98% by mass or less, and especially preferably 96% by mass or less, relative to 100% by mass of the nonvolatile components in the resin composition. When using the resin composition that contains a large amount of (A) the magnetic powder as described above, it has been difficult to fill the first through hole with the resin composition with a conventional method, but with the method according to the embodiment described above, the first through hole can be filled with the resin composition with a superior filling performance.

The resin composition usually contains (B) a thermosetting resin in combination with (A) the magnetic powder. (B) The thermosetting resin as the component (B) can bind (A) the magnetic powder. In addition, (B) the thermosetting resin can react by heat to form a bond, so that the resin composition can be cured. Therefore, the resin composition containing (A) the magnetic powder and (B) the thermosetting resin in combination can form a cured product by the curing.

Illustrative examples of (B) the thermosetting resin may include an epoxy resin, a phenol type resin, an active ester type resin, an amine type resin, an acid anhydride type resin, a benzoxazine type resin, a cyanate ester type resin, and a carbodiimide type resin. (B) The thermosetting resin may be used singly or in a combination of two or more of them.

It is preferable that (B) the thermosetting resin contains (B-1) an epoxy resin. (B-1) The epoxy resin represents the resin having one or more epoxy groups in one molecule thereof. Illustrative examples of (B-1) the epoxy resin may include a bixylenol type epoxy resin, a bisphenol A type epoxy resin; a bisphenol F type epoxy resin; a bisphenol S type epoxy resin; a bisphenol AF type epoxy resin; a dicyclopentadiene type epoxy resin; a trisphenol type epoxy resin; a phenolic novolac type epoxy resin; a glycidylamine type epoxy resin; a glycidyl ester type epoxy resin; a cresol novolac type epoxy resin; a biphenyl type epoxy resin; a linear aliphatic epoxy resin; an epoxy resin containing a butadiene structure; an alicyclic epoxy resin; an alicyclic epoxy resin containing an ester skeleton; a heterocyclic epoxy resin; an epoxy resin containing a spiro ring; a cyclohexane type epoxy resin; a cyclohexane dimethanol type epoxy resin; a trimethylol type epoxy resin; a tetraphenylethane type epoxy resin; epoxy resins containing a fused ring skeleton such as a naphthylene ether type epoxy resin, a tert-butyl-catechol type epoxy resin, a naphthalene type epoxy resin, a naphthol type epoxy resin, an anthracene type epoxy resin, and a naphthol novolac type epoxy resin; an isocyanurate type epoxy resin; an epoxy resin containing an alkyleneoxy skeleton and a butadiene skeleton; and an epoxy resin containing a fluorene structure. (B-1) The epoxy resin may be used singly or in a combination of two or more of them.

It is preferable that (B-1) the epoxy resin contains an epoxy resin having two or more epoxy groups in one molecule thereof. The ratio of the epoxy resin having two or more epoxy groups in one molecule thereof is preferably 50% by mass or more, more preferably 60% by mass or more, and especially preferably 70% by mass or more, relative to 100% by mass of the total amount of (B-1) the epoxy resin.

It is preferable that (B-1) the epoxy resin contains an aromatic structure. When two or more epoxy resins are used, it is preferable that one or more of the epoxy resins contain the aromatic structure. The aromatic structure is the chemical structure that is generally defined as aromatic, including a polycyclic aromatic ring and an aromatic heterocycle.

In (B-1) the epoxy resin, there are an epoxy resin that is in the state of liquid at a temperature of 20°C (hereinafter, this may be referred to as "liquid epoxy resin") and an epoxy resin that is in the state of solid at a temperature of 20°C (hereinafter, this may be referred to as "solid epoxy resin"). (B-1) The epoxy resin may be only the liquid epoxy resin, or only the solid epoxy resin, or a combination of the liquid epoxy resin and the solid epoxy resin. Among them, (B-1) the epoxy resin preferably contains the liquid epoxy resin, especially preferably contains only the liquid epoxy resin.

As for the liquid epoxy resin, the liquid epoxy resin having two or more epoxy groups in one molecule thereof is preferable. The liquid epoxy resin is preferably a bisphenol A type epoxy resin, a bisphenol F type epoxy resin, a bisphenol AF type epoxy resin, a naphthalene type epoxy resin, a glycidyl ester type epoxy resin, a glycidylamine type epoxy resin, a phenol novolac type epoxy resin, an alicyclic epoxy resin containing an ester skeleton, a cyclohexane type epoxy resin, a cyclohexane dimethanol type epoxy resin, an epoxy resin containing a butadiene structure, an epoxy resin containing an alkyleneoxy skeleton and a butadiene skeleton, an epoxy resin containing a fluorene structure, and a dicyclopentadiene type epoxy resin. Among them, the bisphenol A type epoxy resin, the bisphenol F type epoxy resin, the naphthalene type epoxy resin, the glycidylamine type epoxy resin, and the alicyclic epoxy resin containing an ester skeleton are particularly preferable.

Specific examples of the liquid epoxy resin may include "YX7400" manufactured by Mitsubishi Chemical Corp.; "HP4032", "HP4032D", and "HP4032SS", manufactured by DIC Corp. (naphthalene type epoxy resin); "828US", "828EL", "jER828EL", "825", and "Epikote 828EL", manufactured by Mitsubishi Chemical Corp. (bisphenol A type epoxy resin); "jER807" and "1750", manufactured by Mitsubishi Chemical Corp. (bisphenol F type epoxy resin); "jER152" manufactured by Mitsubishi Chemical Corp. (phenol novolac type epoxy resin); "630", "630LSD", and "604", manufactured by Mitsubishi Chemical Corp. (glycidylamine type epoxy resin); "ED-523T" manufactured by Adeka Corp. (glycyrol type epoxy resin); "EP-3950L" and "EP-3980S", manufactured by Adeka Corp. (glycidylamine type epoxy resin); "EP-4088S" manufactured by Adeka Corp. (dicyclopentadiene type epoxy resin); "ZX-1059" manufactured by Nippon Steel Chemical & Material Co., Ltd. (mixture of bisphenol A type epoxy resin and bisphenol F type epoxy resin); "EX-721" manufactured by Nagase ChemteX Corp. (glycidyl ester type epoxy resin); "EX-991L" manufactured by Nagase ChemteX Corp. (epoxy resin containing an alkyleneoxy skeleton); "Celloxide 2021P" and "Celloxide 2081", manufactured by Daicel Corp. (alicyclic epoxy resin containing ester skeleton); "PB-3600" manufactured by Daicel Corp., "JP-100" and "JP-200", manufactured by Nippon Soda Co., Ltd. (epoxy resin containing butadiene structure); "ZX1658" and "ZX1658GS", manufactured by Nippon Steel Chemical & Material Co., Ltd. (liquid 1,4-glycidylcyclohexane type epoxy resin); and "EG-280" manufactured by Osaka Gas Chemicals Co., Ltd. (epoxy resin containing fluorene structure). These liquid epoxy resins may be used singly or in a combination of two or more of them.

As for the solid epoxy resin, the solid epoxy resin having three or more epoxy groups in one molecule thereof is preferable; the aromatic solid epoxy resin having three or more epoxy groups in one molecule thereof is more preferable. The solid epoxy resin is preferably a bixylenol type epoxy resin, a naphthalene type epoxy resin, a naphthalene type four-functional epoxy resin, a cresol novolac type epoxy resin, a dicyclopentadiene type epoxy resin, a trisphenol type epoxy resin, a naphthol type epoxy resin, a biphenyl type epoxy resin, a naphthylene ether type epoxy resin, an anthracene type epoxy resin, a bisphenol A type epoxy resin, a bisphenol AF type epoxy resin, or a tetraphenylethane type epoxy resin; among these, the dicyclopentadiene type epoxy resin is especially preferable.

Specific examples of the solid epoxy resin may include "HP4032H" (naphthalene type epoxy resin) manufactured by DIC Corp.; "HP-4700" and "HP-4710" (naphthalene type four-functional epoxy resin), manufactured by DIC Corp.; "N-690" (cresol novolac type epoxy resin) manufactured by DIC Corp.; "N-695" (cresol novolac type epoxy resin) manufactured by DIC Corp.; "HP-7200", "HP-7200HH", and "HP-7200H" (dicyclopentadiene type epoxy resin), manufactured by DIC Corp.; "EXA-7311", "EXA-7311-G3", "EXA-7311-G4", "EXA-7311-G4S", and "HP6000" (naphthylene ether type epoxy resin), manufactured by DIC Corp.; "EPPN-502H" (trisphenol type epoxy resin) manufactured by Nippon Kayaku Co., Ltd.; "NC7000L" (naphthol novolac type epoxy resin) manufactured by Nippon Kayaku Co., Ltd.; "NC3000H", "NC3000", "NC3000L", and "NC3100" (biphenyl type epoxy resin), manufactured by Nippon Kayaku Co., Ltd.; "ESN475V" (naphthol type epoxy resin) manufactured by Nippon Steel Chemical & Material Co., Ltd.; "ESN485" (naphthol novolac type epoxy resin) manufactured by Nippon Steel Chemical & Material Co., Ltd.; "YX4000H", "YX4000", and "YL6121" (biphenyl type epoxy resin), manufactured by Mitsubishi Chemical Corp.; "YX4000HK" (bixylenol type epoxy resin) manufactured by Mitsubishi Chemical Corp.; "YX8800" (anthracene type epoxy resin) manufactured by Mitsubishi Chemical Corp.; "YX7700" (novolac type epoxy resin containing a xylene structure) manufactured by Mitsubishi Chemical Corp.; "PG-100" and "CG-500", manufactured by Osaka Gas Chemicals Co., Ltd.; "YL7760" (bisphenol AF type epoxy resin) manufactured by Mitsubishi Chemical Corp.; "YL7800" (fluorene type epoxy resin) manufactured by Mitsubishi Chemical Corp.; "jER1010" (solid bisphenol A type epoxy resin) manufactured by Mitsubishi Chemical Corp.; and "jER1031S" (tetraphenylethane type epoxy resin) manufactured by Mitsubishi Chemical Corp. The solid epoxy resins may be used singly or in a combination of two or more of them.

In the case where the epoxy resin is used in a combination of the liquid epoxy resin and the solid epoxy resin, the mass ratio of the liquid epoxy resin with respect to the solid epoxy resin (liquid epoxy resin/solid epoxy resin) is preferably 0.5 or more, more preferably 1 or more, still more preferably 5 or more, and especially preferably 10 or more.

The epoxy equivalent of (B-1) the epoxy resin is preferably 50 g/eq. to 5000 g/eq., more preferably 50 g/eq. to 3000 g/eq., still more preferably 80 g/eq. to 2000 g/eq., and far still more preferably 110 g/eq. to 1000 g/eq. The epoxy equivalent is the mass of the resin per one equivalent of the epoxy group. The epoxy equivalent can be measured by the method in accordance with JIS K7236.

The weight-average molecular weight (Mw) of (B-1) the epoxy resin is preferably 100 to 5000, more preferably 250 to 3000, and still more preferably 400 to 1500. The weight-average molecular weight of the resin can be measured in terms of polystyrene by a gel permeation chromatography (GPC) method.

The amount (% by mass) of (B-1) the epoxy resin contained in the resin composition is preferably 0.1% by mass or more, more preferably 0.5% by mass or more, and especially preferably 1% by mass or more, and is preferably 15% by mass or less, more preferably 10% by mass or less, and especially preferably 5% by mass or less, relative to 100% by mass of the nonvolatile components in the resin composition.

The amount (% by mass) of (B-1) the epoxy resin contained in the resin composition is preferably 10% by mass or more, more preferably 20% by mass or more, and especially preferably 30% by mass or more, and is preferably 80% by mass or less, more preferably 70% by mass or less, and especially preferably 60% by mass or less, relative to 100% by mass of the resin components in the resin composition. The "resin component" in the resin composition means the components excluding inorganic particles such as magnetic powders from the nonvolatile components in the resin composition, unless otherwise specifically mentioned.

When (B) the thermosetting resin contains (B-1) the epoxy resin, (B) the thermosetting resin preferably contains a resin that is capable of undergoing the reaction with (B-1) the epoxy resin to form a bond. Hereinafter, the resin that is capable of undergoing the reaction with (B-1) the epoxy resin to form a bond may be referred to as a "(B-2) curing agent". Illustrative examples of (B-2) the curing agent may include a phenol type resin, an active ester type resin, an amine type resin, a carbodiimide type resin, an acid anhydride type resin, a benzoxazine type resin, a cyanate ester type resin, and a thiol type resin. (B-2) the curing agent may be used singly or in a combination of two or more of them. In particular, a phenol type resin is preferable.

As for the phenol type resin, a resin having one or more, preferably two or more, hydroxyl groups bonding to an aromatic ring such as a benzene ring or a naphthalene ring in one molecule thereof may be used. In view of the heat resistance and the water resistance, a phenol type resin containing a novolac structure is preferable. In view of the adhesion property, a nitrogen-containing phenol type resin is preferable, and a phenol type resin containing a triazine skeleton is more preferable. In particular, from the viewpoint of highly satisfying a heat resistance, a water resistance, and an adhesion property, a phenol novolac resin containing a triazine skeleton is preferable.

Specific examples of the phenol type resin may include "MEH-7700", "MEH-7810", "MEH-7851", and "MEH-8000H", manufactured by Meiwa Plastic Industries, Ltd.; "NHN", "CBN", and "GPH", manufactured by Nippon Kayaku Co., Ltd.; "SN-170", "SN-180", "SN-190", "SN-475", "SN-485", "SN-495", "SN-495V", "SN-375", and "SN-395", manufactured by Nippon Steel Chemical & Material Co., Ltd.; "TD-2090", "TD-2090-60M", "LA-7052", "LA-7054", "LA-1356", "LA-3018", "LA-3018-50P", "EXB-9500", "HPC-9500", "KA-1160", "KA-1163", and "KA-1165", manufactured by DIC Corp.; and "GDP-6115L", "GDP-6115H", and "ELPC75", manufactured by Gun Ei Chemical Industry Co., Ltd.

As for the active ester type resin, a compound having one or more, and preferably two or more active ester groups in one molecule thereof may be used. Among the active ester type resins, the compound having two or more highly reactive ester groups in one molecule thereof is preferable as the active ester type resin, such as a phenol ester compound, a thiophenol ester compound, an N-hydroxylamine ester compound, and an ester compound of a heterocyclic hydroxy compound. The active ester type resin is preferably the compound that is obtained by condensation reaction of a carboxylic acid compound and/or a thiocarboxylic acid compound with a hydroxy compound and/or a thiol compound. Especially, from the viewpoint of improvement of a heat resistance, an active ester type resin obtained from a carboxylic acid compound and a hydroxy compound is preferable, while an active ester type resin obtained from a carboxylic acid compound and a phenol compound and/or a naphthol compound is more preferable. Illustrative examples of the carboxylic acid compound may include benzoic acid, acetic acid, succinic acid, maleic acid, itaconic acid, phthalic acid, isophthalic acid, terephthalic acid, and pyromellitic acid. Illustrative examples of the phenol compound or the naphthol compound may include hydroquinone, resorcin, bisphenol A, bisphenol F, bisphenol S, phenolphthalin, methylated bisphenol A, methylated bisphenol F, methylated bisphenol S, phenol, o-cresol, m-cresol, p-cresol, catechol, α-naphthol, β-naphthol, 1,5-dihydroxy naphthalene, 1,6-dihydroxy naphthalene, 2,6-dihydroxy naphthalene, dihydroxy benzophenone, trihydroxy benzophenone, tetrahydroxy benzophenone, phloroglucin, benzene triol, a dicyclopentadiene type diphenol compound, and phenol novolac. Here, the "dicyclopentadiene type diphenol compound" means a diphenol compound obtained by condensation of one dicyclopentadiene molecule with two phenol molecules.

Specific examples of the preferable active ester type resin may include an active ester type resin containing a dicyclopentadiene type diphenol structure, an active ester type resin containing a naphthalene structure, an active ester type resin containing an acetylated phenol novolac, and an active ester type resin containing a benzoylated phenol novolac. Among them, the active ester type resin containing a naphthalene structure and the active ester type resin containing a dicyclopentadiene type diphenol structure are more preferable. Here, the "dicyclopentadiene type diphenol structure" means the divalent structure unit formed of phenylene-dicyclopentylene-phenylene.

Illustrative examples of the commercially available active ester type resin may include active ester type resins containing a dicyclopentadiene type diphenol structure, such as "EXB9451", "EXB9460", "EXB9460S", "HPC-8000-65T", "HPC-8000H-65TM", and "EXB-8000L-65TM" (manufactured by DIC Corp.); active ester type resins containing a naphthalene structure, such as "EXB-9416-70BK", "EXB-8150-65T", "EXB-8100L-65T", and "EXB-8150L-65T" (manufactured by DIC Corp.); active ester type resins containing an acetylated phenol novolac, such as "DC808" (manufactured by Mitsubishi Chemical Corp.); active ester type resins containing a benzoylated phenol novolac, such as "YLH1026" (manufactured by Mitsubishi Chemical Corp.); active ester type resins as the acetylated phenol novolac, such as "DC808" (manufactured by Mitsubishi Chemical Corp.); and active ester type resins as the benzoylated phenol novolac, such as "YLH1026" (manufactured by Mitsubishi Chemical Corp.), "YLH1030" (manufactured by Mitsubishi Chemical Corp.), and "YLH1048" (manufactured by Mitsubishi Chemical Corp.).

As for the amine type resin, a resin having one or more, and preferably two or more amino groups in one molecule may be used. Illustrative examples of the amine type resin may include an aliphatic amine compound, a polyether amine compound, an alicyclic amine compound, and an aromatic amine compound. Among them, an aromatic amine compound is preferable. The amine type resin is preferably a primary amine and a secondary amine; a primary amine is more preferable. Specific examples of the amine type resin may include 4,4'-methylenebis(2,6-dimethylaniline), diphenyl diaminosulfone, 4,4'-diaminodiphenylmethane, 4,4'-diaminodiphenyl sulfone, 3,3'-diaminodiphenyl sulfone, m-phenylenediamine, m-xylylenediamine, diethyltoluenediamine, 4,4'-diaminodiphenyl ether, 3,3'-dimethyl-4,4'-diaminobiphenyl, 2,2'-dimethyl-4,4'-diaminobiphenyl, 3,3'-dihydroxybenzidine, 2,2-bis(3-amino-4-hydroxyphenyl)propane, 3,3-dimethyl-5,5-diethyl-4,4-diphenylmethanediamine, 2,2-bis(4-aminophenyl)propane, 2,2-bis(4-(4-aminophenoxy)phenyl) propane, 1,3-bis(3-aminophenoxy)benzene, 1,3-bis(4-aminophenoxy)benzene, 1,4-bis(4-aminophenoxy)benzene, 4,4'-bis(4-aminophenoxy)biphenyl, bis(4-(4-aminophenoxy)phenyl) sulfone, and bis(4-(3-aminophenoxy)phenyl) sulfone. Commercially available amine type resins may be used. Illustrative examples thereof may include "KAYABOND C-200S", "KAYABOND C-100", "KAYAHARD A-A", "KAYAHARD A-B", and "KAYAHARD A-S", manufactured by Nippon Kayaku Co. Ltd., as well as "Epicure W" manufactured by Mitsubishi Chemical Corp.

As for the carbodiimide type resin, a resin having one or more, and preferably two or more carbodiimide structures in one molecule may be used. Specific examples of the carbodiimide type resin may include biscarbodiimides including aliphatic biscarbodiimides such as tetramethylene-bis(t-butylcarbodiimide) and cyclohexane-bis(methylene-t-butylcarbodiimide), and aromatic biscarbodiimides such as phenylene-bis(xylylcarbodiimide); and polycarbodiimides including aliphatic polycarbodiimides such as polyhexamethylene carbodiimide, polytrimethylhexamethylene carbodiimide, polycyclohexylene carbodiimide, poly(methylenebiscyclohexylene carbodiimide), and poly(isophorone carbodiimide), and aromatic polycarbodiimides such as poly(phenylene carbodiimide), poly(naphthylene carbodiimide), poly(tolylene carbodiimide), poly(methyldiisopropylphenylene carbodiimide), poly(triethylphenylene carbodiimide), poly(diethylphenylene carbodiimide), poly(triisopropylphenylene carbodiimide), poly(diisopropylphenylene carbodiimide), poly(xylylene carbodiimide), poly(tetramethylxylylene carbodiimide), poly(methylenediphenylene carbodiimide), and poly[methylenebis(methylphenylene) carbodiimide]. Illustrative examples of the commercially available carbodiimide type resin may include "Carbodilite V-02B", "Carbodilite V-03", "Carbodilite V-04K", "Carbodilite V-07", and "Carbodilite V-09", manufactured by Nisshinbo Chemical Inc.; and "Stabaxol P", "Stabaxol P400", and "Hycasyl 510", manufactured by Rhein Chemie GmbH.

As for the acid anhydride type resin, a resin that has one or more acid anhydride groups in one molecule may be used, in which the resin having two or more acid anhydride groups in one molecule is preferable. Specific examples of the acid anhydride type resin may include phthalic anhydride, tetrahydrophthalic anhydride, hexahydrophthalic anhydride, methyl tetrahydrophthalic anhydride, methyl hexahydrophthalic anhydride, methylnadic anhydride, hydrogenated methylnadic anhydride, trialkyl tetrahydrophthalic anhydride, dodecenyl succinic anhydride, 5-(2,5-dioxotetrahydro-3-furanyl)-3-methyl-3-cyclohexene-1,2-dicarboxylic anhydride, trimellitic anhydride, pyromellitic anhydride, benzophenone tetracarboxylic dianhydride, biphenyl tetracarboxylic dianhydride, naphthalene tetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphto[1,2-C]furan-1,3-dione, ethylene glycol bis(anhydrotrimellitate), and a polymer type acid anhydride such as a styrene-maleic acid resin, which is a copolymer of styrene and maleic acid. Illustrative examples of the commercially available product of the acid anhydride type resin may include "HNA-100", "MH-700", "MTA-15", "DDSA", and "OSA", manufactured by New Japan Chemical Co., Ltd.; "YH-306" and "YH-307", manufactured by Mitsubishi Chemical Corp.; "HN-2200" and "HN-5500", manufactured by Hitachi Chemical Co., Ltd.; and "EF-30", "EF-40, "EF-60", and "EF-80", manufactured by Cray Valley S.A.

Specific examples of the benzoxazine type resin may include "JBZ-OD100", "JBZ-OP100D", and "ODA-BOZ", manufactured by JFE Chemical Corp.; "P-d" and "F-a", manufactured by Shikoku Chemicals Corp.; and "HFB2006M" manufactured by Showa Highpolymer Co., Ltd.

Illustrative examples of the cyanate ester type resin may include bifunctional cyanate resins such as bisphenol A dicyanate, polyphenol cyanate, oligo(3-methylene-1,5-phenylenecyanate), 4,4'-methylenebis(2,6-dimethylphenylcyanate), 4,4'-ethylidene diphenyl dicyanate, hexafluorobisphenol A dicyanate, 2,2-bis(4-cyanate)phenylpropane, 1,1-bis(4-cyanatephenylmethane), bis(4-cyanate-3,5-dimethylphenyl)methane, 1,3-bis(4-cyanatephenyl-1-(methylethylidene)) benzene, bis(4-cyanatephenyl) thioether, and bis(4-cyanatephenyl) ether; polyfunctional cyanate resins derived from a phenol novolac, a cresol novolac, and the like; and a prepolymer in which these cyanate resins partially form triazine. Specific examples of the cyanate ester type resin may include "PT30" and "PT60", (phenol novolac type polyfunctional cyanate ester resin); "ULL-950S" (polyfunctional cyanate ester resin); and "BA230" and "BA230S75" (prepolymers in which part or all of bisphenol A dicyanate form triazine so as to be a trimer), manufactured all by Lonza Japan Ltd.

Illustrative examples of the thiol type resin may include trimethylolpropane tris(3-mercaptopropionate), pentaerythritol tetrakis(3-mercaptobutyrate), and tris(3-mercaptopropyl) isocyanurate.

The active group equivalent of (B-2) the curing agent is preferably 50 g/eq. to 3000 g/eq., more preferably 100 g/eq. to 1000 g/eq., still more preferably 100 g/eq. to 500 g/eq., and especially preferably 100 g/eq. to 300 g/eq. The active group equivalent is the mass of (B-2) the curing agent per one equivalent of the active group.

The number of the active groups in (B-2) the curing agent is preferably 0.01 or more, more preferably 0.1 or more, and especially preferably 0.5 or more, and is preferably 10 or less, more preferably 5 or less, and especially preferably 3 or less, relative to one epoxy group in (B-1) the epoxy resin . The active group in (B-2) the curing agent is, for example, an active hydroxy group; they are different depending on kinds of the curing agent. The number of the epoxy groups in (B-1) the epoxy resin is the total value obtained by dividing the mass of the nonvolatile components in each epoxy resin with the epoxy equivalent and adding the divided values for all the epoxy resins. The number of the active groups in (B-2) the curing agent is the total value obtained by dividing the mass of the nonvolatile components in each curing agent with the active group equivalent and adding the divided values for all the curing agents.

The amount (% by mass) of (B-2) the curing agent contained in the resin composition is preferably 0.1% by mass or more, more preferably 0.5% by mass or more, and especially preferably 1% by mass or more, and is preferably 15% by mass or less, more preferably 10% by mass or less, and especially preferably 5% by mass or less, relative to 100% by mass of the nonvolatile components in the resin composition.

The amount (% by mass) of (B-2) the curing agent contained in the resin composition is preferably 10% by mass or more, more preferably 15% by mass or more, and especially preferably 20% by mass or more, and is preferably 70% by mass or less, more preferably 60% by mass or less, and especially preferably 50% by mass or less, relative to 100% by mass of the resin components in the resin composition.

The weight-average molecular weight (Mw) of (B) the thermosetting resin may usually be in the same range as that of the weight-average molecular weight of (B-1) the epoxy resin described above.

The amount (% by mass) of (B) the thermosetting resin contained in the resin composition is preferably 0.1% by mass or more, more preferably 1% by mass or more, and especially preferably 2% by mass or more, and is preferably 15% by mass or less, more preferably 13% by mass or less, and especially preferably 10% by mass or less, relative to 100% by mass of the nonvolatile components in the resin composition.

The amount (% by mass) of (B) the thermosetting resin contained in the resin composition is preferably 40% by mass or more, more preferably 50% by mass or more, and especially preferably 60% by mass or more, and is preferably 95% by mass or less, more preferably 90% by mass or less, and especially preferably 85% by mass or less, relative to 100% by mass of the resin components in the resin composition.

The resin composition may further contain (C) a curing accelerator in combination with the components (A) to (B) described above. (C) The curing accelerator as the component (C) does not include those that fall under the components (A) to (B) described above. (C) The curing accelerator functions as a catalyst to facilitate curing of (B) the thermosetting resin so that this may facilitate curing of the resin composition.

Illustrative examples of (C) the curing accelerator may include a phosphorous type curing accelerator, an amine type curing accelerator, an imidazole type curing accelerator, a guanidine type curing accelerator, and a metal type curing accelerator. Among these, an imidazole type curing accelerator is preferable. (C) The curing accelerator may be used singly or in a combination of two or more of them.

Illustrative examples of the imidazole type curing accelerator may include imidazole compounds such as 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-bezyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-metylimidazolyl-(1')]-ethyl-s-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrro[1,2-a] benzimidazole, 1-dodecyl-2-methyl-3-benzylimidazolium chloride, 2-methylimidazoline, and 2-phenylimidazoline; and adducts of these imidazole compounds with an epoxy resin. Among these, 2-ethyl-4-methylimidazole and 1-benzyl-2-phenylimidazole are preferable. Commercially available products may be used as the imidazole type curing accelerator. Illustrative examples thereof may include "P200-H50" manufactured by Mitsubishi Chemical Corp.; and "Curezol 2MZ", "2E4MZ", "Cl1Z", "Cl1Z-CN", "Cl1Z-CNS", "Cl1Z-A", "2MZ-OK", "2MA-OK", "2MA-OK-PW, and "2PHZ", which are all manufactured by Shikoku Chemicals Corp.

Illustrative examples of the amine type curing accelerator may include: trialkylamines such as triethylamine and tributylamine; and 4-dimethylaminopyridine, benzyl dimethyl amine, 2,4,6-tris(dimethylaminomethyl)phenol, 1,8-diazabicyclo(5,4,0)-undecene, 1,8-diazabicyclo[5,4,0]undecene-7,4-dimethylaminopyridine, and 2,4,6-tris(dimethylaminomethyl)phenol. Among these, 4-dimethylaminopyridine is preferable.

Illustrative examples of the phosphorous type curing accelerator may include triphenyl phosphine, a phosphonium borate compound, tetraphenyl phosphonium tetraphenyl borate, n-butyl phosphonium tetraphenyl borate, tetrabutyl phosphonium decanoate salt, (4-methylphenyl) triphenyl phosphonium thiocyanate, tetraphenyl phosphonium thiocyanate, and butyl triphenyl phosphonium thiocyanate. Among these, triphenyl phosphine and tetrabutyl phosphonium decanoate salt are preferable.

Illustrative examples of the guanidine type curing accelerator may include dicyandiamide, 1-methyl guanidine, 1-ethyl guanidine, 1-cyclohexyl guanidine, 1-phenyl guanidine, 1-(o-tolyl) guanidine, dimethyl guanidine, diphenyl guanidine, trimethyl guanidine, tetramethyl guanidine, pentamethyl guanidine, 1,5,7-triazabicyclo[4.4.0]deca-5-ene, 7-methyl-1,5,7-triazabicyclo[4.4.0]deca-5-ene, 1-methyl biguanide, 1-ethyl biguanide, 1-n-butyl biguanide, 1-n-octadecyl biguanide, 1,1-dimethyl biguanide, 1,1-diethyl biguanide, 1-cyclohexyl biguanide, 1-allyl biguanide, 1-phenyl biguanide, and 1-(o-tolyl) biguanide. Among these, dicyandiamide and 1,5,7-triazabicyclo[4.4.0]deca-5-ene are preferable.

Illustrative examples of the metal type curing accelerator may include organometallic complexes or organometallic salts of metals such as cobalt, copper, zinc, iron, nickel, manganese, and tin. Specific examples of the organometallic complex may include organic cobalt complexes such as cobalt (II) acetylacetonate and cobalt (III) acetylacetonate; organic copper complexes such as copper (II) acetylacetonate; organic zinc complexes such as zinc (II) acetylacetonate; organic iron complexes such as iron (III) acetylacetonate; organic nickel complexes such as nickel (II) acetylacetonate; and organic manganese complexes such as manganese (II) acetylacetonate. Illustrative examples of the organic metal salt may include zinc octylate, tin octylate, zinc naphthenate, cobalt naphthenate, tin stearate, and zinc stearate.

The amount (% by mass) of (C) the curing accelerator contained in the resin composition is preferably 0.001% by mass or more, more preferably 0.005% by mass or more, and especially preferably 0.01% by mass or more, and is preferably 1% by mass or less, more preferably 0.5% by mass or less, and especially preferably 0.1% by mass or less, relative to 100% by mass of the nonvolatile components in the resin composition.

The amount (% by mass) of (C) the curing accelerator contained in the resin composition is preferably 0.01% by mass or more, more preferably 0.05% by mass or more, and especially preferably 0.1% by mass or more, and is preferably 2.0% by mass or less, more preferably 1.0% by mass or less, and especially preferably 0.5% by mass or less, relative to 100% by mass of the resin components in the resin composition.

The resin composition may further contain (D) a thermoplastic resin in combination with the components (A) to (C) described above. (D) The thermoplastic resin as the component (D) does not include those that fall under the components (A) to (C) described above. (D) The thermoplastic resin can effectively improve the mechanical properties of the cured product of the resin composition.

Illustrative examples of (D) the thermoplastic resin may include a phenoxy resin, a polyimide resin, a polyvinyl acetal resin, a polyolefin resin, a polybutadiene resin, a polyamide imide resin, a polyether imide resin, a polysulfone resin, a polyether sulfone resin, a polyphenylene ether resin, a polycarbonate resin, a polyether ether ketone resin, and a polyester resin. (D) The thermoplastic resin may be used singly or in a combination of two or more of them.

Illustrative examples of the phenoxy resin may include phenoxy resins containing one or more skeletons selected from the group consisting of a bisphenol A skeleton, a bisphenol F skeleton, a bisphenol S skeleton, a bisphenol acetophenone skeleton, a novolac skeleton, a biphenyl skeleton, a fluorene skeleton, a dicyclopentadiene skeleton, a norbornene skeleton, a naphthalene skeleton, an anthracene skeleton, an adamantane skeleton, a terpene skeleton, and a trimethylcyclohexane skeleton. The phenoxy resin may be terminated with any functional group, such as a phenolic hydroxyl group or an epoxy group. Specific examples of the phenoxy resin may include "1256" and "4250" (both phenoxy resins containing a bisphenol A skeleton) manufactured by Mitsubishi Chemical Corp.; "YX8100" (phenoxy resin containing a bisphenol S skeleton) manufactured by Mitsubishi Chemical Corp.; "YX6954" (phenoxy resin containing a bisphenol acetophenone skeleton) manufactured by Mitsubishi Chemical Corp.; "FX280" and "FX293" manufactured by Nippon Steel Chemical & Material Co., Ltd.; and "YL7500BH30", "YX6954BH30", "YX7553", "YX7553BH30", "YL7769BH30", "YL6794", "YL7213", "YL7290", "YL7482", and "YL7891BH30", all being manufactured by Mitsubishi Chemical Corp.

Specific examples of the polyimide resin may include "SLK-6100" manufactured by Shin-Etsu Chemical Co., Ltd., and "Rikacoat SN20" and "Rikacoat PN20", both being manufactured by New Japan Chemical Co., Ltd. Specific examples of the polyimide resin may include a linear polyimide obtained by reacting a bifunctional hydroxyl group-terminated polybutadiene, a diisocyanate compound, and a tetrabasic acid anhydride (polyimide described in Japanese Patent Application Laid-open No. 2006-37083), and modified polyimides such as the polyimides containing a polysiloxane skeleton (polyimides described in Japanese Patent Application Laid-open No. 2002-12667 and Japanese Patent Application Laid-open No. 2000-319386).

Illustrative examples of the polyvinyl acetal resin may include a polyvinylformal resin and a polyvinyl butyral resin; here, the polyvinyl butyral resin is preferable. Specific examples of the polyvinyl acetal resin may include "Denka Butyral 4000-2", "Denka Butyral 5000-A", "Denka Butyral 6000-C", and "Denka Butyral 6000-EP", all of them being manufactured by Denka Company Limited; and the S-LEC BH series, the BX series (e.g., BX-5Z), the KS series (e.g., KS-1), the BL series, and the BM series, all of them being manufactured by Sekisui Chemical Co., Ltd.

Illustrative examples of the polyolefin resin may include low-density polyethylene, ultra-low-density polyethylene, high-density polyethylene, ethylene type copolymer resins such as an ethylene-vinyl acetate copolymer, an ethylene-ethyl acrylate copolymer, and an ethylene-methyl acrylate copolymer; and polyolefin type polymers such as polypropylene and an ethylene-propylene block copolymer.

Illustrative examples of the polybutadiene resin may include a resin containing a hydrogenated polybutadiene skeleton, a polybutadiene resin containing a hydroxy group, a polybutadiene resin containing a phenolic hydroxyl group, a polybutadiene resin containing a carboxy group, a polybutadiene resin containing an acid anhydride group, a polybutadiene resin containing an epoxy group, a polybutadiene resin containing an isocyanate group, a polybutadiene resin containing a urethane group, and a polyphenylene ether-polybutadiene resin.

Specific examples of the polyamide imide resin may include "Vylomax HR11NN" and "Vylomax HR16NN", manufactured by Toyobo Co., Ltd. Specific examples of the polyamide imide resin may include modified polyamide imides such as "KS9100" and "KS9300" (polyamide imide containing a polysiloxane skeleton) manufactured by Hitachi Chemical Co., Ltd.

Specific examples of the polyethersulfone resin may include "PES5003P" manufactured by Sumitomo Chemical Co., Ltd.

Specific examples of the polysulfone resin may include polysulfone "P1700" and "P3500", both being manufactured by Solvay Advanced Polymers, Inc.

Specific examples of the polyphenylene ether resin may include "NORYL SA90" manufactured by SABIC. Specific examples of the polyether imide resin may include "Ultem" manufactured by GE.

Illustrative examples of the polycarbonate resin may include a hydroxy group-containing carbonate resin, a phenolic hydroxy group-containing carbonate resin, a carboxy group-containing carbonate resin, an acid anhydride group-containing carbonate resin, an isocyanate group-containing carbonate resin, and a urethane group-containing carbonate resin. Specific examples of the polycarbonate resin may include "FPC0220" manufactured by Mitsubishi Gas Chemical Company, Inc., "T6002" and "T6001" (polycarbonate diol) manufactured by Asahi Kasei Chemicals; and "C-1090", "C-2090", and "C-3090" (polycarbonate diol) manufactured by Kuraray Co., Ltd. Specific examples of the polyether ether ketone resin may include "Sumiploy K" manufactured by Sumitomo Chemical Co., Ltd.

Illustrative examples of the polyester resin may include a polyethylene terephthalate resin, a polyethylene naphthalate resin, a polybutylene terephthalate resin, a polybutylene naphthalate resin, a polytrimethylene terephthalate resin, a polytrimethylene naphthalate resin, and a polycyclohexanedimethyl terephthalate resin.

The weight-average molecular weight (Mw) of (D) the thermoplastic resin is preferably more than 5,000, more preferably 8,000 or more, still more preferably 10,000 or more, and especially preferably 20,000 or more. The upper limit thereof is not particularly restricted; this may be, for example, 1,000,000 or less, 500,000 or less, or 100,000 or less.

The amount (% by mass) of (D) the thermoplastic resin contained in the resin composition is preferably 0.01% by mass or more, more preferably 0.05% by mass or more, and especially preferably 0.1% by mass or more, and is preferably 5% by mass or less, more preferably 3% by mass or less, and especially preferably 2% by mass or less, relative to 100% by mass of the nonvolatile components in the resin composition.

The amount (% by mass) of (D) the thermoplastic resin contained in the resin composition is preferably 1% by mass or more, more preferably 5% by mass or more, and especially preferably 10% by mass or more, and is preferably 40% by mass or less, more preferably 30% by mass or less, and especially preferably 20% by mass or less, relative to 100% by mass of the resin components in the resin composition.

The resin composition may further contain (E) a dispersant in combination with the components (A) to (D) described above. (E) The dispersant as the component (E) does not include those that fall under the components (A) to (D) described above. According to (E) the dispersant, the dispersibility of (A) the magnetic powder can be effectively enhanced.

As for (E) the dispersant, a compound that can reduce the viscosity of the resin composition may be used. Illustrative examples of (E) the dispersant may include a phosphate ester type dispersant, a polyoxyalkylene type dispersant, an acetylene type dispersant, a silicone type dispersant, an anionic dispersant, and a cationic dispersant. (E) The dispersant may be used singly or in a combination of two or more of them. Among these, the phosphate ester type dispersant is preferable.

Among the phosphate ester type dispersants, a polyether type phosphate ester dispersant is preferable. The polyether type phosphate ester dispersant is the phosphate ester type dispersant containing a poly(alkyleneoxy) structure in the molecule. Illustrative examples of the polyether type phosphate ester dispersant may include a polyoxyalkylene alkyl ether phosphate ester and a polyoxyalkylene alkyl phenyl ether phosphate ester. Among these, the polyoxyalkylene alkyl ether phosphate ester is especially preferable.

The polyoxyalkylene alkyl ether phosphate ester may have a structure in which one to three alkyl-oxy-poly(alkyleneoxy) groups are bonded to the phosphorous atom of a phosphate salt. The number of alkyleneoxy units (number of repeating units) of the poly(alkyleneoxy) moiety in the alkyl-oxy-poly(alkyleneoxy) group is preferably 2 to 30, and more preferably 3 to 20. The alkylene group in the poly(alkyleneoxy) moiety is preferably an alkylene group having 2 to 4 carbon atoms. Illustrative examples of the alkylene group may include an ethylene group, a propylene group, an isopropylene group, a butylene group, and an isobutyl group. Furthermore, the alkyl group in the alkyl-oxy-poly(alkyleneoxy) group is preferably an alkyl group having 6 to 30 carbon atoms, and more preferably an alkyl group having 8 to 20 carbon atoms. Illustrative examples of the alkyl group may include a decyl group, an undecyl group, a dodecyl group, a tridecyl group, a tetradecyl group, a pentadecyl group, a hexadecyl group, a heptadecyl group, and an octadecyl group. When the polyoxyalkylene alkyl ether phosphate ester has a plurality of alkyl-oxy-poly(alkyleneoxy) groups, a plurality of alkyl groups may be the same or different. Furthermore, a plurality of alkylene groups may be the same or different.

The acid value of the polyether type phosphate ester dispersant is preferably 10 mg-KOH/g or more, and more preferably 15 mg-KOH/g or more, and is preferably 200 mg-KOH/g or less, and more preferably 150 mg-KOH/g or less. The acid value may be measured by the neutralization titration method.

Illustrative examples of the commercially available phosphate ester type dispersant may include polyether type phosphate ester dispersants (e.g., "ED152", "ED153", "ED154", "ED118", "ED174", and "ED251" of the HIPLAAD series), all being manufactured by Kusumoto Chemicals, Ltd.; and "RS-410", "RS-610", and "RS-710" of the Phosphanol series manufactured by Toho Chemical Industry Co., Ltd.

Illustrative examples of the polyoxyalkylene type dispersant may include a polyoxyethylene alkyl ether, a polyoxyethylene alkyl ester, a polyoxyethylene sorbitan fatty acid ester, a polyoxyethylene alkyl phenyl ether, a polyoxyethylene alkylamine, and a polyoxyethylene alkylamide. Illustrative examples of the commercially available polyoxyalkylene type dispersant may include "AKM-0531", "AFB-1521", "SC-0505K", "SC-1015F", "SC-0708A", and "HKM-50A" of the "Malialim" series manufactured by NOF Corp.

Illustrative examples of the acetylene type dispersant may include acetylene glycol. Illustrative examples of the commercially available acetylene type dispersant may include "82", "104", "440", "465", "485", and "Olefin Y" of the "Surfynol" series manufactured by Air Products and Chemicals Inc.

Illustrative examples of the silicone type dispersant may include polyether-modified polydimethylsiloxane, polyether-modified siloxane, and polyester-modified polydimethylsiloxane. Illustrative examples of the commercially available silicone type dispersant may include "BYK 347" and "BYK 348", both being manufactured by BYK Chemie GmbH.

Illustrative examples of the anionic dispersant may include sodium polyacrylate, sodium dodecylbenzyl sulfonate, sodium laurylate, ammonium polyoxyethylene alkyl ether sulfate, and sodium carboxymethyl cellulose salt. Illustrative examples of the commercially available anionic dispersant may include "PN-411" and "PA-111", both being manufactured by Ajinomoto Fine-Techno Co., Inc.; and "A-550" and "PS-1900", both being manufactured by Lion Corp.

Illustrative examples of the cationic dispersant may include a polyacrylate type resin containing an amino group and a polystyrene type resin containing an amino group. Illustrative examples of the commercially available cationic dispersant may include "161", "162", "164", "182", "2000", and "2001", all being manufactured by BYK Chemie GmbH; "PB-821", "PB-822", and "PB-824", all being manufactured by Ajinomoto Fine-Techno Co., Inc.; "V-216" and "V-220", both being manufactured by ISP Japan, Ltd.; and "Solsperse 13940", "Solsperse 24000", and "Solsperse 32000", all being manufactured by Lubrizol, Inc.

(E) The dispersant may be used singly or in a combination of two or more of them.

The amount (% by mass) of (E) the dispersant contained in the resin composition is preferably 0.01% by mass or more, more preferably 0.1% by mass or more, and especially preferably 0.2% by mass or more, and is preferably 5% by mass or less, more preferably 3% by mass or less, and especially preferably 2% by mass or less, relative to 100% by mass of the nonvolatile components in the resin composition.

The amount (% by mass) of (E) the dispersant contained in the resin composition is preferably 1% by mass or more, more preferably 5% by mass or more, and especially preferably 10% by mass or more, and is preferably 40% by mass or less, more preferably 30% by mass or less, and especially preferably 20% by mass or less, relative to 100% by mass of the resin components in the resin composition.

The resin composition may further contain (F) an optional additive as an optional component in combination with the components (A) to (E) described above. (F) The optional additive as the component (F) does not include those that fall under the components (A) to (E) described above. Illustrative examples of (F) the optional additive may include: radical-polymerizable compounds such as a maleimide type radical-polymerizable compound, a vinylphenyl type radical-polymerizable compound, a (meth)acrylic type radical-polymerizable compound, an allyl type radical-polymerizable compound, and a polybutadiene type radical-polymerizable compound; radical polymerization initiators such as a peroxide type radical polymerization initiator and an azo type radical polymerization initiator; inorganic fillers such as a silica particle; organic fillers such as a rubber particle; organic metal compounds such as an organic copper compound and an organic zinc compound; polymerization inhibitors such as hydroquinone, catechol, pyrogallol, and phenothiazine; leveling agents such as a silicone type leveling agent and an acrylic polymer type leveling agent; thickeners such as bentone and montmorillonite; antifoaming agents such as a silicone type antifoaming agent, an acrylic type antifoaming agent, a fluorine type antifoaming agent, and a vinyl resin type antifoaming agent; ultraviolet absorbers such as a benzotriazole type ultraviolet absorber; adhesion enhancers such as a urea silane; adhesion assisting agents such as a triazole type adhesion assisting agent, a tetrazole type adhesion assisting agent, and a triazine type adhesion assisting agent; antioxidants such as a hindered phenol type antioxidant; flame retardants such as phosphorous type flame retardants (for example, a phosphate ester compound, a phosphazene compound, a phosphinate compound, and red phosphorus), nitrogen type flame retardants (for example, melamine sulfate), halogen type flame retardants, and inorganic type flame retardants (for example, antimony trioxide); and stabilizers such as a borate type stabilizer, a titanate type stabilizer, an aluminate type stabilizer, a zirconate type stabilizer, an isocyanate type stabilizer, a carboxylate type stabilizer, and a carboxylic anhydride type stabilizer. (F) The optional additive may be used singly or in a combination of two or more of them.

The resin composition may further contain (G) a solvent as a volatile component in combination with the nonvolatile components such as the components (A) to (F) described above. An organic solvent is usually used as (G) the solvent. Illustrative examples of the organic solvent may include: ketone type solvents such as acetone, methyl ethyl ketone, methyl isobutyl ketone, and cyclohexanone; ester type solvents such as methyl acetate, ethyl acetate, butyl acetate, isobutyl acetate, isoamyl acetate, methyl propionate, ethyl propionate, and γ-butyrolactone; ether type solvents such as tetrahydropyran, tetrahydrofuran, 1,4-dioxane, diethyl ether, diisopropyl ether, dibutyl ether, and diphenyl ether; alcohol type solvents such as methanol, ethanol, propanol, butanol, and ethyleneglycol; ether ester type solvents such as 2-ethoxyethyl acetate, propyleneglycol monomethyl ether acetate, diethyleneglycol monoethyl ether acetate, ethyldiglycol acetate, γ-butyrolactone, and methyl methoxypropionate; ester alcohol type solvents such as methyl lactate, ethyl lactate, and methyl 2-hydroxyisobutyrate; ether alcohol type solvents such as 2-methoxypropanol, 2-methoxyethanol, 2-ethoxyethanol, propyleneglycol monomethyl ether, and diethyleneglycol monobutyl ether (butyl carbitol); amide type solvents such as N,N-dimethylformamide, N,N-dimethylacetamide, and N-methyl-2-pyrrolidone; sulfoxide type solvents such as dimethyl sulfoxide; nitrile type solvents such as acetonitrile and propionitrile; aliphatic hydrocarbon type solvents such as hexane, cyclopentane, cyclohexane, and methylcyclohexane; and aromatic hydrocarbon type solvents such as benzene, toluene, xylene, ethylbenzene, and trimethylbenzene. (G) The solvent may be used singly or in a combination of two or more of them.

The amount of (G) the solvent is set preferably so that the melt viscosity of the resin composition or the resin composition layer containing the resin composition can be adjusted to an appropriate range. From the viewpoint of effectively suppressing the void formation, it is preferable to contain less solvent in the resin composition contained in the resin composition layer. The range of the amount (% by mass) of (G) the solvent is preferably 5% or less, more preferably 3% or less, especially 1% or less, and ideally 0%, relative to 100% by mass of the resin composition. In other words, the resin composition may not contain (G) the solvent. The amount of the solvent contained in the resin composition can be measured by the method described in <Test Example 1: measurement of the amount of the residual solvent in the resin composition> in Examples to be described later.

The resin composition contained in the resin composition layer usually has a high minimum melt viscosity. The range of the minimum melt viscosity of the resin composition may be, for example, 5000 poise or more, 7500 poise or more, or 10000 poise or more. The resin composition containing (A) the magnetic powder usually has a high minimum melt viscosity as described above, so that in general the resin composition is prone to be difficult to smoothly fill the first through hole. However, according to the method according to the embodiment described above, filling of the resin composition into the first through hole can be achieved even when the resin composition having such a high minimum melt viscosity is used. From the viewpoint of smooth filling, the upper limit of the minimum melt viscosity of the resin composition is preferably 50,000 poise or less, more preferably 45,000 poise or less, and especially preferably 40,000 poise or less. The minimum melt viscosity of the resin composition can be measured in the temperature range from 60°C to 160°C. Specifically, the minimum melt viscosity of the resin composition can be measured by the method described in <Test Example 2: measurement of the minimum melt viscosity of the resin composition> in Examples to be described later.

When the resin composition is cured, the cured product thereof can be obtained. For example, the resin composition containing (B) the thermosetting resin can form the cured product by thermally curing. Usually, among the components contained in the resin composition, volatile components such as (G) the solvent may be volatilized by heat during the curing, while nonvolatile components such as the components (A) to (F) are not volatilized by heat during the curing. Therefore, the cured product of the resin composition may contain non-volatile components of the resin composition or reaction products thereof.

The cured product of the resin composition described above can have superior magnetic properties. Therefore, the cured product layer that contains the cured product can also have superior magnetic properties. In the preferable embodiment, the cured product of the resin composition and the cured product layer containing the cured product can have a high relative magnetic permeability and a low magnetic loss.

For example, the range of the relative magnetic permeability (μ') of the cured product of the resin composition is preferably 5 or more, more preferably 7 or more, still more preferably 9 or more, and especially preferably 11 or more. There is no particular restriction in the upper limit thereof. The upper limit may be, for example, 30 or less. The relative magnetic permeability of the cured product can be measured using the 3-turn coil method at a measurement frequency of 20 MHz and a room temperature of 23°C. Specifically, the relative magnetic permeability of the cured product of the resin composition can be measured by the method described in <Test Example 3: measurement of the relative magnetic permeability and magnetic loss tangent of the cured product of the resin composition> in Examples to be described later.

For example, the range of the magnetic loss (μ") of the cured product of the resin composition is preferably 0.10 or less, more preferably 0.08 or less, still more preferably 0.06 or less, and especially preferably 0.05 or less. The lower limit thereof is ideally 0.00 or more, but usually 0.01 or more. The magnetic loss of the cured product can be measured using the 3-turn coil method at a measurement frequency of 20 MHz and a room temperature of 23°C. Specifically, the magnetic loss of the cured product of the resin composition can be measured by the method described in <Test Example 3: measurement of the relative magnetic permeability and magnetic loss tangent of the cured product of the resin composition> in Examples to be described later.

The thickness of the resin composition layer depends on the thickness of the core substrate and the size of the first through hole, but this is preferably thin. Even when using the resin composition layer that is too thin to fill the first through hole by the conventional method, by the method according to the embodiment described above, the first through hole can be filled with the resin composition contained in the resin composition layer. For example, the thickness of the resin composition layer included in the resin sheet can be less than the depth of the first through hole, or may be less than half the depth of the first through hole. In the preferable embodiment, the range of the thickness of the resin composition layer is preferably 5 $\mu$m or more, more preferably 10 $\mu$m or more, and especially preferably 50 $\mu$m or more, and is preferably 600 $\mu$m or less, more preferably 300 $\mu$m or less, still more preferably 200 $\mu$m or less, and especially preferably 150 $\mu$m or less.

The resin sheet may be further include an optional member as needed. Examples of the optional member may include a protective film, which is formed on the surface of the resin composition layer not being in contact with the support (namely, on the surface opposite with respect to the support). The thickness of the protective film is not particularly restricted; the thickness is, for example, 1 $\mu$m to 40 $\mu$m. When the protective film is formed, the surface of the resin composition layer can be prevented from attachment of dirt and formation of a scar. When the resin sheet including the protective film is used, the protective film is usually removed before the step (I).

The resin sheet may be a single leaf sheet or a long-length sheet. The "long-length sheet" represents the sheet having the length that is 10 times or more the width thereof, unless otherwise specifically mentioned. The length is preferably 20 times or more than the width, and specifically, this may be long enough to be rolled up so as to be stored or transported. There is no particular restriction in the upper limit of the length; so, this may be, for example, 100,000 times with respect to the width or less.

The resin sheet can be produced, for example, by the method that includes forming the resin composition layer on the support. The resin composition layer can be formed, for example, by the method that includes preparing the resin composition and then applying the resin composition onto the support.

The resin composition can be produced, for example, by mixing those components described earlier. These components may be mixed in part or in whole at the same time or in sequence. In the course of mixing of each component, the temperature may be set as appropriate; therefore, temporarily or throughout the entire process, heating and/or cooling may be carried out. In addition, in the course of mixing of each component, stirring or shaking may be carried out.

For ease of application, the resin composition to be applied is preferably prepared as a liquid resin varnish. When the resin composition is not in the form of liquid, the nonvolatile components of the resin composition may be mixed with a solvent as needed to obtain a resin varnish. The resin composition may be formed by the method that includes, for example, mixing the nonvolatile components of the resin composition with a solvent to prepare a resin varnish, applying the resin varnish onto a support surface, and drying the applied resin varnish, in this order. As the solvents described above, (C) the solvent (G) may be used.

The application may be performed using coating equipment such as a die coater. Drying may be carried out, for example, by a drying method such as heating or blowing a hot air. The drying condition is not particularly restricted; the drying is performed in such a way that the amount of the solvent in the resin composition layer is brought into the range described earlier. Drying may be performed, for example, under the condition of 50°C to 150°C for 3 minutes to 10 minutes, although these conditions may vary depending on the boiling point of the solvent in the resin varnish.

[Examples]

Hereinafter, the present invention will be specifically described by Examples. The present invention is not limited to these Examples. In the description below, "part" and "%" that describe quantity mean "part by mass" and "% by mass", respectively, unless otherwise specifically mentioned. Unless otherwise specifically mentioned, the following operations were performed at normal temperature and normal pressure (23°C and 1 atm). In the explanation described hereinafter, "MEK" means methyl ethyl ketone unless otherwise specifically mentioned.

<Production Example 1: production of the resin sheet>

1.6 parts by mass of the epoxy resin ("ZX-1059" manufactured by Nippon Steel Chemical & Materials Co., ltd.; a mixture of bisphenol A type epoxy resin and bisphenol F type epoxy resin; epoxy equivalent of 169 g/eq.; specific gravity of 1.18 g/cm$^3$), 1.9 parts by mass of the phenol resin containing a triazine skeleton ("LA-7054" manufactured by DIC Corp.; hydroxyl group equivalent of about 125 g/eq.; MEK solution with 60% solid component; specific gravity of the solid component of 1.31 g/cm$^3$), 1.6 parts by mass of the phenoxy resin ("YX7553BH30" manufactured by Mitsubishi Chemical Corp.; 1:1 MEK/cyclohexanone solution with 30% solid component; specific gravity of the solid component of 1.18 g/cm$^3$), 0.7 parts by mass of the dispersant ("ED-152" manufactured by Kusumoto Chemicals, Ltd.; polyether phosphate ester; specific gravity of 1.00 g/cm$^3$), 3.5 parts by mass of the solvent (cyclohexanone), 0.01 parts by mass of the imidazole type curing accelerator ("2E4MZ" manufactured by Shikoku Chemicals Corp.; 2-ethyl-4-methylimidazole; specific gravity of 0.97 g/cm$^3$), 20 parts by mass of the magnetic powder ("M03S" manufactured by Powdertech, Inc.; Fe-Mn type ferrite; average particle diameter of 0.5 $\mu$m; specific gravity of 5.1 m$^2$/g), and 56 parts by mass of the magnetic powder ("AKT-PB" manufactured by Mitsubishi Steel Mfg. Co., Ltd.; Fe-Ni type alloy; average particle diameter of 5.0 $\mu$m; specific gravity of 8.1 m$^2$/g) were mixed to prepare a magnetic varnish.

A PET film ("Lumirror R80" manufactured by Toray Industries, Inc.; thickness of 38 $\mu$m; softening temperature of 130°C; hereinafter, this may be referred to as "release PET") treated with an alkyd resin type releasing agent ("AL-5" manufactured by Lintec Inc.) was prepared. The aforementioned magnetic varnish was applied onto this release PET by means of a die coater such that the thickness of the resin composition layer after drying became 100 $\mu$m, which was then followed by drying at 65°C to 120°C (average 100°C) for 6 minutes to obtain a resin sheet.

<Test Example 1: measurement of the amount of the residual solvent in the resin composition>

The resin sheet was cut to the piece of a 10-cm square to obtain a sheet piece. The mass $W_A$ of this sheet piece (sheet piece before drying) was measured.

Next, the sheet piece, cut to the piece of a 10-cm square, was dried at 130°C for 15 minutes. The mass $W_B$ of this dried sheet piece was measured.

Finally, the release PET used as the support for the resin sheet was cut to the piece of a 10-cm square, and then its mass $W_C$ was measured.

The amount of the residual solvent in the resin composition was determined by applying the measured masses $W_A$, $W_B$, and $W_C$ to the Formula 1 below.

$$\text{Amount of residual solvent (\%)} = (W_A - W_B)/(W_A - W_C) \times 100$$
(Formula 1)

From the measurement result, the amount of the residual solvent was 0.5%.

<Test Example 2: measurement of the minimum melt viscosity of the resin composition>

The release PET was removed from the resin sheet to obtain the resin composition layer. The resin composition layer was compressed in a mold to prepare pellets for measurement (diameter of 18 mm and weight of 3.4 g to 3.6 g). With regard to 1 g of the pellets for measurement, the dynamic viscoelastic modulus was measured by heating in the temperature range from a starting temperature of 60°C to 160°C with a temperature raising rate of 5°C/min.; then, the minimum melt viscosity (poise) was calculated. The dynamic viscoelastic modulus was measured using a dynamic viscoelasticity measuring instrument ("Rheosol-G3000" manufactured by UBM Ltd.) and a parallel plate having a diameter of 18 mm under the measurement condition of the measurement temperature interval of 2.5°C, the frequency of 1 Hz, and the strain of 1 deg. From the result of the measurement, the minimum melt viscosity of the resin composition was 12000 poise.

<Test Example 3: measurement of the relative magnetic permeability and magnetic loss tangent of the cured product of the resin composition>

The resin sheet was cut so as to be the size of a 200-mm square. The cut resin sheet (200-mm square) was laminated using a batch-type vacuum pressing laminator ("CVP700" manufactured by Nikko-Materials Co., Ltd.; two-stage build-up laminator) onto one surface of a polyimide film ("Iupilex 25S" manufactured by UBE Corp.; thickness of 25 $\mu$m, 240-mm square). The lamination was carried out in such a way that the resin composition layer of the resin sheet was in contact with the center of the smooth surface as the one surface of the polyimide film. The lamination was carried out by evacuating over 30 seconds to bring the air pressure to 13 hPa or less, followed by press-adhering with the pressure of 0.74 MPa at 100°C for 30 seconds. By lamination as described above, an intermediate laminated body including the resin composition layer and the polyimide film was obtained.

The obtained intermediate laminated body was heated at 190°C for 90 minutes to thermally cure the resin composition layer, which was then followed by removing the polyimide film to obtain the cured product in the form of a sheet. The obtained cured product in the form of a sheet was cut to obtain the evaluation sample having a width of 5 mm and a length of 18 mm. The relative magnetic permeability ($\mu'$) and the magnetic loss ($\mu''$) of the evaluation sample were measured at a room temperature of 23°C and the measurement frequency of 20 MHz by the 3-turn coil method using the measurement instrument ("HP8362B" manufactured by Agilent Technologies, Inc.). The magnetic loss tangent ($\mu''$) was calculated using the magnetic loss tangent (tan$\delta$) by the formula [tan$\delta=\mu''/\mu'$]. As the result of the measurement, the

relative magnetic permeability ($\mu$') was 20 and the magnetic loss ($\mu$") was 0.016.

[Example 1]

(1) Preparation of the core substrate

Through holes were formed in a both-surface copper clad epoxy resin-impregnated glass cloth laminated substrate ("R1515A" manufactured by Panasonic Corp.; thickness of the copper foil: 18 $\mu$m, thickness of the substrate: 0.8 mm) to prepare a core substrate. The through holes were the cylindrical holes having a diameter of 350 $\mu$m with an interval of 100 $\mu$m between the through holes.

(2) Filling the holes with the resin sheet

A batch-type vacuum pressing laminator ("CVP700" manufactured by Nikko-Materials Co., Ltd.; 2-stage build-up laminator) was prepared. This laminator included a first chamber for press-adhering and a second chamber for hot pressing. The first chamber was provided with a first stage (stage for rubber press) capable of pressing the sample with a flat plate having a rubber sheet as the elastic member formed on the surface thereof. The second chamber was provided with a second stage (stage for SUS press) capable of pressing the sample with a flat plate (rigid plate) formed of a stainless steel.

From the resin sheet produced in Production Example 1, resin sheet pieces of a 200-mm square were cut out. The resulting resin sheet pieces were placed on both sides of the core substrate such that the resin composition layer of the resin sheet was in contact with the center of the core substrate to obtain a sample multi-layered body having a layer structure of resin sheet piece/core substrate/resin sheet piece. By using the aforementioned batch-type vacuum pressing laminator, the resin composition was filled into the through holes in the core substrate according to the following procedure.

Specifically, the sample multi-layered body was supplied to the first stage of the laminator, and then the enclosed space accommodating the sample multi-layered body in the first stage was evacuated for 30 seconds to obtain an air pressure of 1.3 kPa or less, and then the sample multi-layered body was pressed at the temperature of 100°C and the pressure of 15 kgf/cm$^2$ for 60 seconds (press-adhering step). The air pressure (vacuum degree) in the enclosed space during the pressing in the first stage was 0.1 kPa.

Next, the sample multi-layered body was conveyed to the second stage, and then the enclosed space accommodating the sample multi-layered body in the second stage was evacuated for 30 seconds to obtain an air pressure of 1.3 kPa or less, and then the sample multi-layered body was pressed at the temperature of 100°C and the pressure of 15 kgf/cm$^2$ for 300 seconds (hot pressing step). The air pressure (vacuum degree) in the enclosed space in the second stage during the pressing was 0.1 kPa.

(3) Thermal curing of the resin composition

The sample multi-layered body was taken out from the laminator, and the release PET of the resin sheet was removed. Then, the resin composition was cured at 130°C for 30 minutes, and then at 180°C for 30 minutes to obtain a magnetic substrate.

[Example 2]

The resin composition was filled into the through holes in the core substrate by using only the second stage of the batch-type vacuum pressing laminator without using the first stage. Except for this matter, the magnetic substrate was obtained in the same way as in Example 1.

[Example 3]

The pressing condition using the second stage of the batch-type vacuum pressing laminator was changed to the temperature of 140°C and the period of 60 seconds. Except for this matter, the magnetic substrate was obtained in the same way as in Example 2.

[Comparative Example 1]

During the pressing using the second stage of the batch-type vacuum pressing laminator, the enclosed space of the second stage was not evacuated. Therefore, the pressing using the second stage was performed in an environment of an atmospheric pressure. Except for this matter, the magnetic substrate was obtained in the same way as in Example 1.

[Comparative Example 2]

The resin composition was filled into the through holes in the core substrate by using only the first stage of the batch-type vacuum pressing laminator without using the second stage. Except for this matter, the magnetic substrate was obtained in the same way as in Example 1.

[Comparative Example 3]

From the resin sheet produced in Production Example 1, resin sheet pieces of a 200-mm square were cut out. The resulting resin sheet pieces were placed on both sides of the core substrate such that the resin composition layers of the resin sheets were in contact with the center of the core substrate. Further, on the resin sheet, a release film ("Aflex 50N NT", manufactured by AGC Inc.), a cushion paper ("AACP-9N", manufactured by Awa Paper & Technological, Inc.), and a SUS plate (1 mm thick) were placed in this order so as to cover the entire resin sheet to obtain a sample multi-layered body having the layer structure of SUS plate/cushion paper/release film/resin sheet/core substrate/resin sheet/release film/cushion paper/SUS plate.

The sample multi-layered body was placed in a hot press machine (KVHC, manufactured by Kitagawa Seiki Co., Ltd.). With evacuating inside the press machine, the hot pressing was carried out at the temperature of 100°C and the pressure of 15 kgf/cm$^2$ for 300 seconds. The air pressure inside the press machine during the hot pressing was 2 kPa.

The sample multi-layered body was taken out from the press machine, and then the SUS plate, the cushion paper, the release film, and the release PET of the resin sheet were removed. Then, the resin composition was cured at 130°C for 30 minutes, and then at 180°C for 30 minutes to obtain the magnetic substrate.

<Test Example 4: confirmation of filling performance>

The cross section of the magnetic substrate was observed. Specifically, the magnetic substrate was whittled so as to form a cross section that was parallel with respect to the thickness direction of the magnetic substrate and passed through the center of the through hole. The cross section was observed by a digital microscope ("VHX-7000" manufactured by Keyence Corp.). From the observed image, the presence or absence of the vacant space (unfilled portion) without the cured product and the void in the through holes was confirmed. Observations were made for randomly chosen 10 through holes. The results of the observation were judged according to the following criteria.

○: There are no voids in the through holes and the through holes are filled with the cured product without forming a vacant space.

Δ: The through holes are filled with the cured product without forming a vacant space, but there are some voids.

X: There is an unfilled portion in the through holes because a part of the through hole is not filled with the cured product.

[Results]

The results of Examples and Comparative Examples are summarized in Table below.

[Table 1]

| Table 1. Results of Examples and Comparative Examples] | | | | | | |
|---|---|---|---|---|---|---|
| | Example | | | Comparative Example | | |
| | 1 | 2 | 3 | 1 | 2 | 3 |
| Equipment | 2-Chamber laminator | 2-Chamber laminator | 2-Chamber laminator | 2-Chamber laminator | 2-Chamber laminator | Vacuum hot press |
| Rubber press | | | | | | |
| Vacuum degree | 0.1kPa | - | - | 0.1kPa | 0.1kPa | - |
| Time | 1 minute | - | - | 1 minute | 1 minute | - |
| Temperature | 100 °C | - | - | 100 °C | 100 °C | - |
| Pressure | 15kgf/cm$^2$ | - | - | 15kgf/cm$^2$ | 15kgf/cm$^2$ | - |
| SUS press | | | | | | |

(continued)

| Table 1. Results of Examples and Comparative Examples] | | | | | | |
|---|---|---|---|---|---|---|
| | Example | | | Comparative Example | | |
| | 1 | 2 | 3 | 1 | 2 | 3 |
| Vacuum de-gree | 0.1kPa | 0.1kPa | 0.1kPa | - | - | - |
| Time | 5 minutes | 5 minutes | 1 minute | 5 minutes | - | - |
| Temperature | 100 °C | 100 °C | 140 °C | 100 °C | - | - |
| Pressure | 15kgf/cm$^2$ | 15kgf/cm$^2$ | 15kgf/cm$^2$ | 15kgf/cm$^2$ | - | - |
| Vacuum press | | | | | | |
| Vacuum de-gree | - | - | - | - | - | 2kPa |
| Time | - | - | - | - | - | 5 minutes |
| Temperature | - | - | - | - | - | 100 °C |
| Pressure | - | - | - | - | - | 15kgf/cm$^2$ |
| Filling perfor-mance | O | O | O | Δ | X | Δ |

Reference Signs List

1          laminator

2          laminator

10         core substrate

10D        main surface

10U        main surface

11         first through hole

20         resin sheet

21         support

22         resin composition layer

30         resin sheet

31         support

32         resin composition layer

40         magnetic substrate

41         filled cured product layer

41D        surface

41U       surface

42        adhering cured product layer

43        adhering cured product layer

44        second through hole

51        conductor layer

52        conductor layer

53        conductor layer

100       stage (hot press stage)

110       lower pressing member

111       lower supporting member

111U      supporting surface

112       lower plate

112U      pressing surface

113       lower frame member

114       heater

115       fixed frame portion

116       movable frame portion

117       elastic supporting portion

120       upper pressing member

121       upper supporting member

121D      supporting surface

122       upper plate

122D      pressing surface

123       upper frame member

124       heater

125       nozzle

130       hydraulic cylinder

131       piston rod

200       stage (press-adhering stage)

210     lower pressing member

211     lower supporting member

211U    supporting surface

212     lower plate

212U    pressing surface

213     lower frame member

214     heater

215     fixed frame portion

216     movable frame portion

217     elastic supporting portion

220     upper pressing member

221     upper supporting member

221D    supporting surface

222     upper plate

222D    pressing surface

223     upper frame member

224     heater

225     nozzle

230     hydraulic cylinder

231     piston rod

**Claims**

1. A production method for a magnetic substrate using a resin sheet that comprises a support and a resin composition layer formed on the support; wherein

   the resin composition layer comprises a resin composition containing a magnetic powder;
   the production method comprises
   a step (I) of placing the resin sheet on a core substrate having a through hole formed therein, and
   a step (II) of pressing the resin sheet with a rigid plate to fill the through hole with the resin composition; and
   the step (II) includes performing the pressing in such a way that the rigid plate is in contact with the resin sheet, under heating condition of 80°C or higher and 160°C or lower at a vacuum degree of 1.3 kPa or less.

2. The production method for the magnetic substrate according to claim 1, wherein

   the step (I) includes placing the resin sheets on both sides of the core substrate, and
   the step (II) includes pressing the resin sheets placed on both sides of the core substrate with the rigid plate.

3. The production method for the magnetic substrates according to claim 1, wherein the pressing at the step (II) is performed under the pressure condition of 5 kgf/cm$^2$ or higher.

4. The production method for the magnetic substrate according to claim 1, including a step (III) of curing the resin composition after the step (II).

5. The production method for the magnetic substrate according to claim 4, including a step (IV) of polishing the cured resin composition after the step (III).

6. The production method for the magnetic substrate according to claim 4, wherein

   the step (III) includes forming a cured product layer comprising a cured product of the resin composition in the through hole; and
   the production method includes, after the step (III), a step (V) of forming a through hole in the cured product layer in the through hole.

7. The production method for the magnetic substrate according to claim 4, including a step (VI) of forming a conductor layer after the step (III).

8. The production method for the magnetic substrate according to claim 1, wherein an amount of the magnetic powder is 65% by volume or more relative to 100% by volume of nonvolatile components in the resin composition.

9. The production method for the magnetic substrate according to claim 1, wherein a thickness of the resin composition layer included in the resin sheet is 150 μm or less.

# FIG.1

# FIG.2

40

10U    11    43

10    42

10D    41

# FIG.3

40

10U    41U

10

10D    41D    41

# FIG.4

# FIG.5

# FIG.6

# FIG.7

EP 4 498 768 A1

| | | |
|---|---|---|
| **INTERNATIONAL SEARCH REPORT** | International application No.<br><br>**PCT/JP2023/005791** | |

**A. CLASSIFICATION OF SUBJECT MATTER**

*H05K 1/16*(2006.01)i
FI:  H05K1/16 B

According to International Patent Classification (IPC) or to both national classification and IPC

**B. FIELDS SEARCHED**

Minimum documentation searched (classification system followed by classification symbols)

H05K1/16

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2021-61264 A (AJINOMOTO CO., INC.) 15 April 2021 (2021-04-15)<br>   entire text, all drawings | 1-9 |
| A | JP 2021-86856 A (IBIDEN CO., LTD.) 03 June 2021 (2021-06-03)<br>   entire text, all drawings | 1-9 |
| A | JP 2021-97130 A (IBIDEN CO., LTD.) 24 June 2021 (2021-06-24)<br>   entire text, all drawings | 1-9 |
| A | WO 2018/194099 A1 (AJINOMOTO CO., INC.) 25 October 2018 (2018-10-25)<br>   entire text, all drawings | 1-9 |

☐ Further documents are listed in the continuation of Box C.    ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **01 May 2023** | **16 May 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

International application No.

**PCT/JP2023/005791**

| Patent document cited in search report | | | Publication date (day/month/year) | Patent family member(s) | | | Publication date (day/month/year) |
|---|---|---|---|---|---|---|---|
| JP | 2021-61264 | A | 15 April 2021 | EP entire text, all drawings | 3800651 | A1 | |
| JP | 2021-86856 | A | 03 June 2021 | US entire text, all drawings | 2021/0159010 | A1 | |
| JP | 2021-97130 | A | 24 June 2021 | (Family: none) | | | |
| WO | 2018/194099 | A1 | 25 October 2018 | (Family: none) | | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004149758 A
- JP 4992514 B
- JP 2016100546 A
- JP 2021086856 A
- JP 6812091 B
- JP 2016197624 A
- JP 2006037083 A
- JP 2002012667 A
- JP 2000319386 A